Europäisches Patentamt

European Patent Office

Office européen des brevets

(19)

(11) EP 0 991 087 A2

(12) EUROPEAN PATENT APPLICATION

(43) Date of publication:
05.04.2000 Bulletin 2000/14

(51) Int Cl.⁷: $H01F\ 10/14$, $H01F\ 10/28$, $H01F\ 10/08$

(21) Application number: 99307630.6

(22) Date of filing: 28.09.1999

(84) Designated Contracting States:
AT BE CH CY DE DK ES FI FR GB GR IE IT LI LU MC NL PT SE
Designated Extension States:
AL LT LV MK RO SI

(30) Priority: 28.09.1998 JP 27340598
26.04.1999 JP 11850699

(71) Applicant: Matsushita Electric Industrial Co., Ltd.
Kadoma-shi, Osaka-fu, 571-8501 (JP)

(72) Inventor: Nago, Kumio
Nara 639-1136 (JP)

(74) Representative: Tomlinson, Kerry John
Frank B. Dehn & Co.,
European Patent Attorneys,
179 Queen Victoria Street
London EC4V 4EL (GB)

(54) **Soft magnetic thin film, soft magnetic multi-layered film, producing method thereof and magnetic device using them**

(57)    The present invention provides a soft magnetic film having high saturation magnetic flux density and an excellent soft magnetic property in a high-frequency bandwidth of not less than several hundred MHz. The soft magnetic film contains Fe as a main component and M (at least one kind of element selected from 4A-group element, 5A-group element and 6A-group element), at least one of selected from Pt and Pd, and N.

EP 0 991 087 A2

**Description**

The present invention relates to a soft magnetic thin film and a soft magnetic multi-layered film used in an antenna for a liquid crystal television set, an electromagnetic interference restrainer, a noise filter, a pulse motor, a choke coil, a transformer, an inductor, a magnetic impedance device, a magnetic head, etc. and a production method thereof, and a magnetic device using them.

In addition, the present invention relates to an electromagnetic interference restrainer for reducing noises between and in electronic equipment, and more specifically, relates to an electromagnetic interference restrainer for reducing noises superposed in a cable, etc. for transmitting a signal or electric power, and a cable using it.

In recent years, information communication equipment, such as a personal computer, an electronic note pad, and a portable telephone, have been quickly developed. Further, as techniques for supporting the multimedia world, it is predicted that high performance image, sound and information communicating equipment processing various data such as characters, sound, static images and dynamic images will form a great part of the market.

Due to such a background, size-reduction, thinning, lightening, digitization and frequency increase of the electronic equipment have been carried out quickly. Moreover, as the digitization and frequency increase of the electronic equipment are carried out, the problem of electromagnetic wave noises becomes more serious.

Under such conditions, a need for size-reduction, thinning, and performance improvement of a magnetic device becomes higher. A semiconductor device of parts composing an electronic equipment such as image, sound and information communicating equipment has been reduced in size early by a thin-film part and integration due to the development of LSI techniques, but size-reduction and thinning of a magnetic device due to a thin-film part and integration have fallen behind the times.

Therefore, according to the request for size-reduction, thinning and performance improvement of magnetic devices such as an antenna for a liquid crystal television set, an electromagnetic interference restrainer, a noise filter, pulse motor, a choke coil, a transformer, an inductor, a magnetic impedance device and a magnetic head, a high-performance magnetic material has been required recently.

As magnetic core material used for the magnetic devices, it is required that a soft magnetic property where high saturation magnetic flux density and high-frequency property are excellent and a thin form can be obtained easily. Therefore, a demand for thinning a film is high, and thus a need for developing a thin-film magnetic device using a soft magnetic thin film as a core material with excellent high saturation magnetic flux density and high-frequency property becomes higher.

Conventionally, crystalline alloy, such as Sendust, Permalloy and silicon steel, and Co-based amorphous alloy have been examined as the above magnetic core materials. However, in order to cope with the size-reduction, thinning and performance improvement of the magnetic device, a soft magnetic film with higher performance, which has both the high saturation magnetic flux density and high-frequency property, is required.

Incidentally, when $\mu'$ is a real part and $\mu''$ is an imaginary part, permeability $\mu$ is represented as follows:

$$\mu = \mu' - i\mu'' \tag{1}$$

Here, $i = (-1)^{1/2}$. $\mu'$ corresponds to effective permeability, and $\mu''$ corresponds to a loss. As the magnetic core material which can be used in a high-frequency bandwidth, it is required that $\mu'$ is high and $\mu''$ is low up to the high-frequency bandwidth.

The above-mentioned crystalline alloy, such as Sendust, Permalloy and silicon steel, and Co-based amorphous alloy have excellent soft magnetic properties, but their saturation magnetic flux density is low, namely, about 1T, and the silicon steel has high saturation magnetic flux density but its soft magnetic property is not satisfactory.

Therefore, as a material having a high saturation magnetic flux density of not less than 1T, Fe-M-N thin film (herein, M is at least one kind of element of Zr, Hf, Ti, Nb, Ta, V, Mo, W and Cr) has been researched and developed.

However, as disclosed in Japanese Patent Application Laid-Open No. 2-275605 (1990), the Fe-M-N thin film cannot obtain high permeability in a high-frequency bandwidth, and thus cannot obtain the satisfactory high-frequency property such that it can be used in the above-mentioned thin film magnetic device.

Meanwhile, as the size-reduction, thinning, lightening, digitization and frequency-heightening of electronic equipment are quickly developed, the equipment itself malfunctions and electromagnetic wave noises generated from the equipment cause malfunction of other equipment, and the problem of the electromagnetic noises becomes more serious.

Most of switching ICs in a digital circuit substrate generate noises, and unnecessary electromagnetic wave (noise) is radiated from a conductor, a signal cable or the like on the substrate as an antenna. Since a signal cable used in an electronic equipment serves as an induction path for radiation of noises, a ferrite core of a bulk with a ring form is positioned as an electromagnetic interference restrainer around the cable so as to cope with noises.

However, in recent years, since high-density mounting is made in electronic equipment that requires size-reduction, thinning and lightening, it is necessary to narrow a connector gap and a cable gap, and thus a large-sized ferrite core cannot cope with such a problem.

Furthermore, since the product of permeability μ by a resonance frequency is constant in the ferrite core due to limit of a snake, it is difficult to increase a frequency in principle, and thus an applicable frequency is not more than several hundred MHz. The ferrite core cannot be used with an EMI specification bandwidth where a frequency is increased from several MHz to not less than 1 GHz.

Further, when a lot of ferrite cores are positioned as the electromagnetic interference restrainer around a cable, flexibility of the cable deteriorates.

In a noise filter using a magnetic material, magnetic loss is utilized for electromagnetic absorption. In order to obtain high magnetic loss, it is required that an impedance Z is high and resistance R is higher than reactance X in the applicable frequency bandwidth. When the resistance is R and the reactance is X, the impedance Z is represented by:

$$Z = R + iX \tag{2}$$

Here, $i = (-1)^{1/2}$.

This corresponds to permeability μ being high, while imaginary part μ" is larger than real part μ'. The permeability μ where μ' is the real part and μ" is imaginary part is represented by the above equation (1).

It is an object of the present invention to provide a higher-performance soft magnetic film and a soft magnetic multi-layered film having both excellent soft magnetic properties, namely, high saturation magnetic flux density and high-frequency property. Further, it is an object of the present invention to realize size-reduction, thinning and performance improving of a magnetic device by using the soft magnetic film or soft magnetic multi-layered film.

It is another object of the present invention to provide an electromagnetic interference restrainer that can be used suitably at an operation frequency of not less than several hundreds MHz and a cable using it.

It is still another object of the present invention to provide a method of producing the soft magnetic film and soft magnetic multi-layered film.

The inventors found according to the results of studies that an Fe-M-(Pt,Pd)-N thin film is a magnetic core material having soft magnetic properties of high saturation magnetic flux density and excellent high frequency property.

Here, M is at least one kind of element selected from 4A-group element, 5A-group element and 6A-group element in the periodic table according to IUPAC. M is, for example, at least one of Zr, Hf, Ti, Nb, Ta, V, Mo, W and Cr. It is preferable that M is the 4A-group element and Hf is particularly preferable.

The thin film having the high saturation magnetic flux density and excellent high frequency property is used so that the magnetic device can be minimized and lightened, and its performance can be improved.

An electromagnetic interference restrainer and a magnetic impedance device of the present invention has a soft magnetic thin film including a soft magnetic thin film containing Fe as a main component and further containing M and X. Here, X is at least one kind of element selected from B, C, N and O. The inventors found that the soft magnetic thin film obtains high performance in the high frequency bandwidth of not less than several hundreds MHz, and has the property suitable for specified devices such as the electromagnetic interference restrainer and magnetic impedance device.

Certain embodiments of the invention will now be described by way of example and with reference to the accompanying drawings.

FIG. 1 is a cross-section showing a soft magnetic thin film according to one embodiment of the present invention.

FIG. 2 is a diagram showing a change in saturation magnetic flux density of the soft magnetic film with respect to nitrogen partial pressure ratio when the soft magnetic thin film is produced.

FIG. 3 is a diagram showing a change in a coercive force of the soft magnetic thin film with respect to the nitrogen partial pressure ratio when the soft magnetic thin film is produced.

FIGS. 4A through 4H are diagrams showing a change of X-ray diffraction pattern with respect to the nitrogen partial pressure ratio when the soft magnetic thin film is produced.

FIG. 5 is a diagram showing one example of a frequency property of permeability of the soft magnetic thin film of the present invention.

FIG. 6 is a diagram showing one example of a frequency property of normalized permeability of the soft magnetic thin film of the present invention.

FIG. 7 is a diagram showing one example of a relationship between a heat treatment temperature and saturation magnetic flux density of the soft magnetic thin film of the present invention.

FIG. 8 is a diagram showing one example of a relationship between the heat treatment temperature and coercive force of the soft magnetic thin film of the present invention.

FIG. 9 is a diagram showing another example of the relationship between the heat treatment temperature and saturation magnetic flux density of the soft magnetic thin film of the present invention.

FIG. 10 is a diagram showing another example of the relationship between the heat treatment temperature and coercive force of the soft magnetic thin film of the present invention.

FIG. 11 is a diagram showing still another example of the relationship between the heat treatment temperature and saturation magnetic flux density of the soft magnetic thin film of the present invention.

FIG. 12 is a diagram showing still another example of the relationship between the heat treatment temperature and coercive force of the soft magnetic thin film of the present invention.

FIG. 13 is a diagram showing still another example of the relationship between the heat treatment temperature and saturation magnetic flux density of the soft magnetic thin film of the present invention.

FIG. 14 is a diagram showing still another example of the relationship between the heat treatment temperature and coercive force of the soft magnetic thin film of the present invention.

FIG. 15 is a diagram showing an example of a change in the X-ray diffraction pattern with respect to the heat treatment temperature of an Fe-Hf-Pt-N thin film of the present invention.

FIG. 16 is a diagram showing another example of a change in the X-ray diffraction pattern with respect to the heat treatment temperature of an Fe-Hf-Pt-N thin film of the present invention.

FIG. 17 is a diagram showing still another example of a change in the X-ray diffraction pattern with respect to the heat treatment temperature of an Fe-Hf-Pt-N thin film of the present invention.

FIG. 18 is a diagram showing still another example of a change in the X-ray diffraction pattern with respect to the heat treatment temperature of an Fe-Hf-Pt-N thin film of the present invention.

FIG. 19 is a cross-section showing a soft magnetic film according to one embodiment of the present invention.

FIG. 20 is a cross-section showing the soft magnetic film according to another embodiment of the present invention.

FIG. 21 is a cross-section showing a soft magnetic multi-layered film according to one embodiment of the present invention.

FIG. 22 is a cross-section showing the soft magnetic multi-layered film according to another embodiment of the present invention.

FIG. 23 is a cross-section showing the soft magnetic multi-layered film according to still another embodiment of the present invention.

FIG. 24 is a cross-section showing the soft magnetic multi-layered film according to still another embodiment of the present invention.

FIG. 25 is a perspective view showing a noise filter as a magnetic device according to one embodiment of the present invention.

FIG. 26 is a perspective view showing a noise filter as a magnetic device according to another embodiment of the present invention.

FIG. 27 is a perspective view showing the use of a plurality of the noise filters shown in FIG. 25 are arranged.

FIG. 28 is a perspective view showing a thin film transformer as a magnetic device according to one embodiment of the present invention.

FIG. 29 is a plan view showing a thin film inductor as a magnetic device according to one embodiment of the present invention.

FIG. 30 is a partial cross-section of the thin film inductor having a conductor film shown in FIG. 29.

FIG. 31 is a plan view showing a thin film magnetic head as a magnetic device according to one embodiment of the present invention.

FIG. 32 is a partial cross-section of the thin film magnetic head shown in FIG. 31.

FIG. 33 is a partial cross-section showing the thin film magnetic head as a magnetic device according to another embodiment of the present invention.

FIG. 34 is a plan view showing a magnetic impedance device as a magnetic device according to one embodiment of the present invention.

FIG. 35 is a cross-section of the magnetic impedance device shown in FIG. 34.

FIGS. 36A and 36B are perspective views of an electromagnetic interference restrainer according to one embodiment of the present invention.

FIGS. 37A through 37C are perspective views of an electromagnetic interference restrainer according to one embodiment of the present invention.

FIG. 38 is an example showing the mounting of the electromagnetic interference restrainer of the present invention to a cable.

FIG. 39 is another example of the mounting electromagnetic interference restrainer of the present invention to a cable.

FIG. 40 is a cross-section of a cable according to one embodiment of the present invention containing the electromagnetic interference restrainer.

FIGS. 41A through 41C are cross-sections of the cable according to one embodiment of the present invention containing the electromagnetic interference restrainer.

FIG. 42 is a diagram showing a change in the real part $\mu'$ of permeability in the film surface of the soft magnetic film with respect to a bias current at the time of deposition.

It is preferable that a soft magnetic thin film of the present invention has a composition that contains Fe as a main component and more specifically contains Fe in an amount of 50 atomic % or more. It is preferable that the soft magnetic thin film of the present invention has a composition including at least one kind of element, in an amount of 0.1 to 20 atomic %, selected from Pt and Pd. It is particularly preferable that the soft magnetic thin film of the present invention has a composition which contains Fe as a main component and includes N in an amount of 1 to 35 atomic % and M in an amount of 0.1 to 20 atomic %, and includes at least one kind of element Pt or Pd in an amount of 0.1 to 20 atomic %. It is preferable that the soft magnetic thin film of the present invention is composed of an amorphous phase and/or crystallite phase. In this specification, the crystallite phase is a phase whose average crystal particle diameter is not more than 10 nm.

Since Pt and/or Pd is added in the soft magnetic thin film of the present invention, its permeability is improved in a bandwidth of not less than several hundred MHz, for example, a frequency of 1 GHz, compared with the case where Pt and/or Pd is not added.

The present invention includes a soft magnetic film having a double layered structure in which the soft magnetic thin film is formed on an Si thin film. The soft magnetic thin film is formed on the Si thin film in such a manner so that more excellent soft magnetic properties can be obtained. Moreover, the soft magnetic film from another viewpoint of the present invention is formed in such a manner that a plurality of double layered films are laminated. Since the soft magnetic film can be thickened, a core material having excellent soft magnetic properties can be provided.

A soft magnetic multi-layered film of the present invention is formed such that the soft magnetic layer and a non-magnetic film are laminated alternately. The soft magnetic film may be a single soft magnetic thin film or a multi-layered film including an Si thin film or the like. In the soft magnetic multi-layered film, even when the magnetic layer is thickened, generation of an eddy current due to magnetic induction between the laminated magnetic films can be suppressed. As a result, an excellent magnetic core material having a high-frequency property can be provided.

It is preferable that the soft magnetic multi-layered film is composed of the non-magnetic films having at least two kinds of film thicknesses.

In addition, it is preferable that the soft magnetic multi-layered film is composed of the soft magnetic films having at least two kinds of film thicknesses.

The soft magnetic multi-layered film including at least two kinds of thicknesses of the soft magnetic films or the nonmagnetic films can provide an excellent higher-frequency property.

It is preferable that the non-magnetic films include a non-magnetic film having a thickness of 0.5 to 50 nm, and a non-magnetic film having a thickness of 50 to 500 nm. The thin non-magnetic film of about 0.5 to 50 nm provides high saturation magnetic flux density and high permeability and strengthens magnetostatic coupling between the magnetic layers. The thick non-magnetic film of about 50 to 500 nm secures electric insulation between the magnetic layers and restrains eddy current loss. Therefore, the non-magnetic films have two types of thicknesses so that the eddy current loss can be reduced with the high saturation magnetic flux density and high permeability being maintained due to the effects of the respective non-magnetic films. As a result, the high frequency property can be improved.

In addition, it is preferable that the soft magnetic multi-layered film has at least a pair of soft magnetic films adjacent to each other and separated by a non-magnetic film whose directions showing high permeability in the film plane are different from each other. This is because unnecessary electromagnetic waves that enter in various directions and at various angles can be absorbed.

It is preferable that the soft magnetic thin film, soft magnetic film and soft magnetic multi-layered film are applied to magnetic devices such as an antenna for a liquid crystal television set, an electromagnetic interference restrainer, a noise filter, a pulse motor, a choke coil, a transformer, an inductor, a magnetic impedance device and a magnetic head.

In a magnetic device in which high impedance should be required in a high-frequency bandwidth, particularly, an electromagnetic interference restrainer and a magnetic impedance device, a soft magnetic thin film that contains Fe as a main component and M and X can be used instead of the soft magnetic thin film containing Pt and/or Pd.

It is preferable that the electromagnetic interference restrainer of the present invention is a laminated layer including a soft magnetic film and a non-magnetic insulation film. Moreover, it is preferable that the laminated layer further includes a conductive film. Further, it is preferable that the laminated layer has flexibility such that it can be wound around a cable. It is preferable that the soft magnetic film includes at least one kind of element selected from Pt and Pd. A preferable content range of Pt and/or Pd is the same as the above one. Further, it is preferable that the soft magnetic film has a thickness of not more than I $\mu$m in the electromagnetic interference restrainer. This is because a thick soft magnetic film is not required in order to cope with a noise in the high-frequency bandwidth. Moreover, in this case, X is preferably () (oxygen).

The electromagnetic interference restrainer formed as a laminated layer is suitable for a signal cable. In the case where this is used for a signal cable, the electromagnetic interference restrainer may be wound around the cable, or it may be provided previously in the cable.

It is preferable that the soft magnetic film is formed on a cooled substrate. Moreover, it is preferable that the soft magnetic multi-layered film is produced by alternately forming the soft magnetic film and the non-magnetic film on a cooled substrate. They are formed on the cooled substrate so that only an amorphous phase and/or crystallite phase can be formed just after the deposition.

In addition, it is preferable that the soft magnetic multi-layered film is formed by applying different biases to the soft magnetic films adjacent to each other via the non-magnetic film. In this case, a soft magnetic film, to which a bias is not applied (non-bias), may be included.

In this soft magnetic multi-layered film, a control is made so that directions showing high permeability in the film planes of the soft magnetic films (direction of uniaxial shape magnetic anisotropy) adjacent to each other via the non-magnetic film become different from each other.

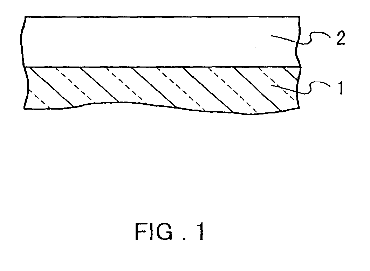

There will be detailed below the soft magnetic film including Fe-M-Pt-N system soft magnetic thin film with reference to FIGS. 1 through 20 in embodiments 1 through 3.

(Embodiment 1)

Alloy was used as a target and an Fe-M-(Pt,Pd)-N thin film 2 (herein, M is at least one kind of 4A-group, 5A-group and 6A-group elements such as Zr, Hf, Ti, Nb, Ta, V, Mo, W and Cr) was prepared with a radio-frequency diode sputtering device according to a reactive sputtering method where $N_2$ gas is introduced into Ar gas. In FIG. 1, the Fe-M-(Pt,Pd)-N thin film 2 having a thickness of 1 $\mu$m is formed on a Si substrate 1 cooled by water. The prepared Fe-M-(Pt,Pd)-N thin film underwent a heat treatment at a predetermined temperature for 1 hour in a vacuum of not more than $1 \times 10^{-3}$ and in a static magnetic field of 48 kA/m.

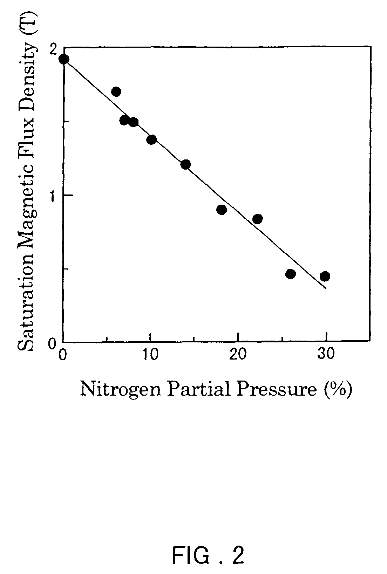

FIG. 2 is a graph showing a change in saturation magnetic flux density Bs with respect to a nitrogen partial pressure ratio of the Fe-Hf-Pt-N thin film prepared in a state that the nitrogen partial pressure ratio is changed within a range of 0 to 30 %. The heat treatment was executed at 250°C for 1 hour.

As shown in FIG. 2, the saturation magnetic flux density decreases monotonically as the nitrogen partial pressure ratio increases. When the nitrogen partial pressure ratio is about not more than 16 %, the saturation magnetic flux density obtains a value of 1 to 2 T.

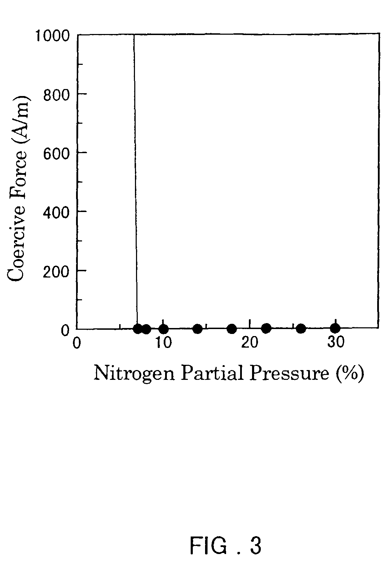

FIG. 3 shows a change in a coercive force Hc with respect to the nitrogen partial pressure ratio that was obtained by measuring the Fe-Hf-Pt-N thin films in a hard magnetization direction. The heat treatment was executed at 250°C for 1 hour.

As shown in FIG. 3, in a range that the nitrogen partial pressure ratio is 0 to 6 %, the coercive force shows a value which greatly exceeds 1000 A/m (not shown), but when the nitrogen partial pressure ratio is not less than 7 %, the coercive force shows a small value of not more than 5 A/m.

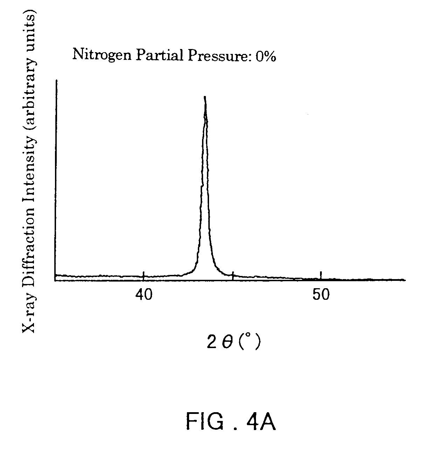

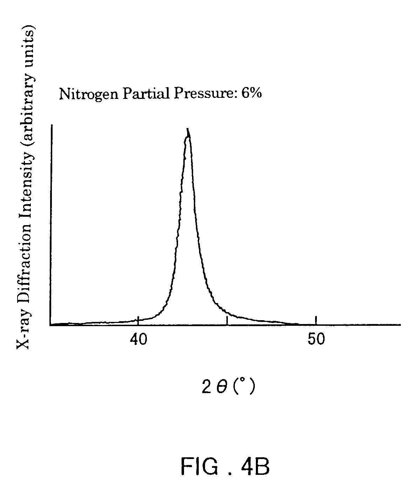

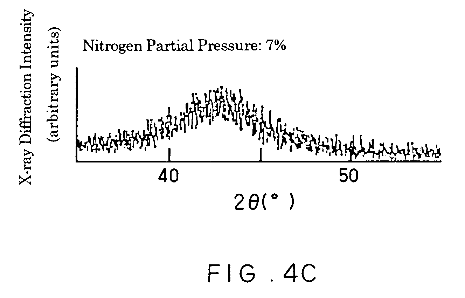

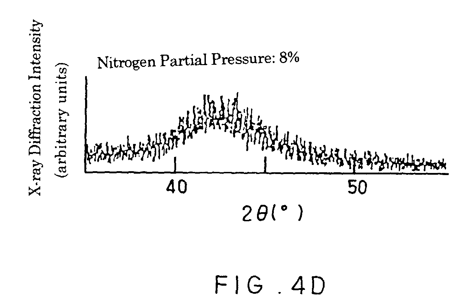

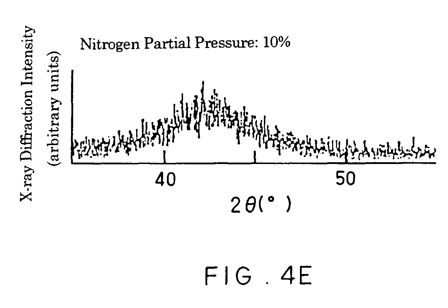

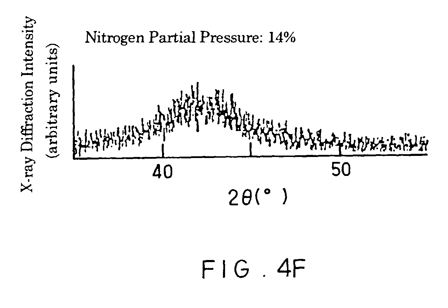

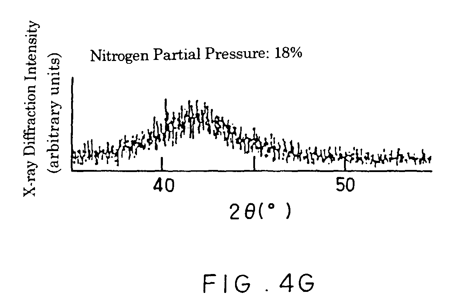

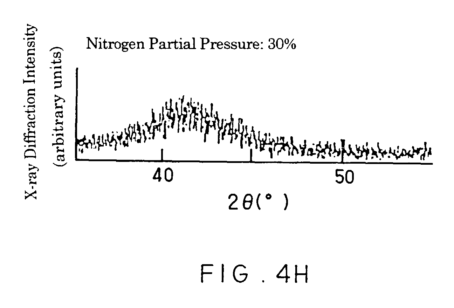

FIG. 4 is a graph showing a change in an X-ray diffraction pattern with respect to the nitrogen partial pressure ratio of the Fe-Hf-Pt-N thin films. The heat treatment was executed at 250°C for 1 hour.

As shown in FIGS. 4A through 4H, in an Fe-Hf-Pt-N thin film where the nitrogen partial pressure ratio is not more than 6 % and thus the coercive force obtains a large value of not less than 1000 A/m, a sharp diffraction peak was observed and a crystalline state was obtained. However, in an Fe-Hf-Pt-N thin film where the nitrogen partial pressure ratio is not less than 7 % and thus the low coercive force of not more than 5 A/m (satisfactory soft magnetic) can be obtained, a broad diffraction peak was observed, and an amorphous phase and/or crystallite phase were obtained.

Next, a result of measuring a frequency property of the permeability of the soft magnetic film is shown. The permeability was measured by the one-turn coil method in a frequency bandwidth of 10 MHz to 1 GHz along a hard magnetization direction of the soft magnetic film.

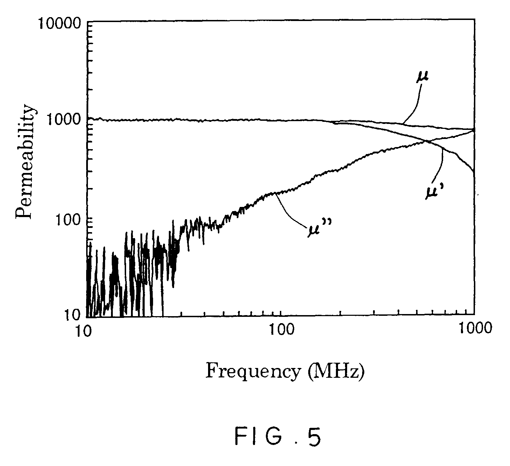

FIG. 5 is a graph showing the frequency property of the permeability of a Fe-Hf-Pt-N thin film that was prepared with a nitrogen partial pressure of 7% and underwent heat treatment at 250°C for 1 hour. The composition of this soft magnetic film was such that Fe was 72 atomic %, Hf was 4 atomic %, Pt was 8.5 atomic % and N is 15.5 atomic % (hereinafter, represented by $Fe_{72}Hf_4Pt_{8.5}N_{15.5}$) as a result of analysis by a wavelength dispersive X-ray microanalyzer (XMA).

As shown in FIG. 5, a real part $\mu'$ of the permeability was about 1000 in 100 MHz, and was about 200 in 1 GHz, and thus high permeability was obtained. Moreover, a peak of an imaginary part $\mu''$ is obtained in a frequency bandwidth of not less than 1 GHz, and effective permeability $\mu$ obtains constant values in a high-frequency bandwidth of 10 MHz to 1 GHz. As a result, an excellent frequency property is obtained.

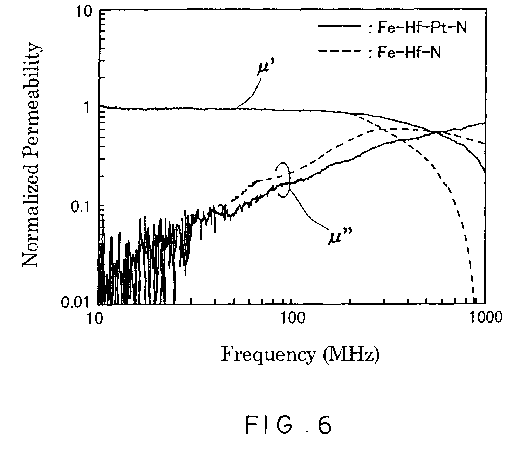

FIG. 6 is a graph showing the frequency property of permeability obtained by normalizing $\mu'$ of the $Fe_{72}Hf_4Pt_{8.5}N_{15.5}$ by a value of a low frequency. For comparison, a frequency property of normalized permeability of the Fe-Hf-N ($Fe_{80.5}Hf_4N_{15.5}$) having the same thickness (1 $\mu$m) that was prepared under the same condition is represented by a broken line in FIG. 6.

As shown in FIG. 6, in the Fe-Hf-Pt-N thin film, $\mu''$ shifts to a high frequency side and attenuation of $\mu'$ is improved greatly in a bandwidth of not less than several hundred MHz compared with the Fe-Hf-N thin film.

An anisotropic magnetic field Hk of the $Fe_{72}Hf_4Pt_{8.5}N_{15.5}$ thin film is about 1200 A/m, and this value is about twice as large as the Hk (about 600 A/m) of the $Fe_{80.5}Hf_4N_{15.5}$ thin film.

Compared with the Fe-Hf-N thin film, the Fe-Hf-Pt-N thin film shows the more excellent high frequency property because the anisotropic magnetic filed is strong and thus a resonance frequency shifts to the high-frequency side.

Next, the result of examining changes in the saturation magnetic flux density Bs and coercive force Hc of the Fe-Hf-Pt-N thin film with respect to the heat treatment are shown.

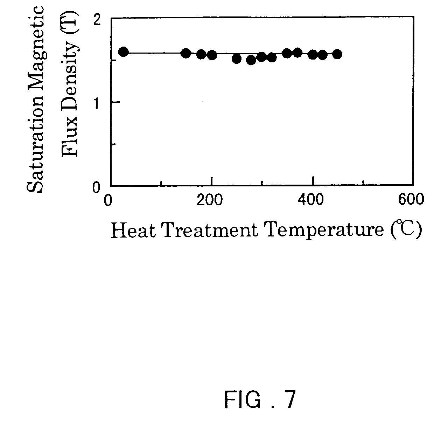

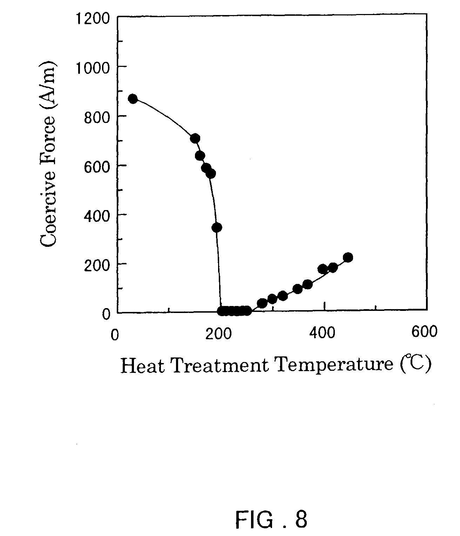

FIGS. 7 and 8 respectively show the changes in the saturation magnetic flux density and coercive force of the $Fe_{72}Hf_4Pt_{8.5}N_{15.5}$ thin film with respect to the heat treatment.

As shown in FIG. 7, the saturation magnetic flux density obtains approximately constant values of 1.5 to 1.6 T from the state just after the deposition to the heat treatment at 450°C.

In addition, as shown in FIG. 8, the coercive force in the state just after the deposition obtains a large value of about 870 A/m. However, as the heat treatment temperature rises, the coercive force is gradually decreased, and the coercive force is abruptly decreased due to the heat treatment at 200°C and obtains a small value of not more than 1A/m. This low value of the coercive force is maintained up to 250°C. Further, as the heat treatment temperature rises, the coercive force is gradually increased in a temperature range higher than 250°C.

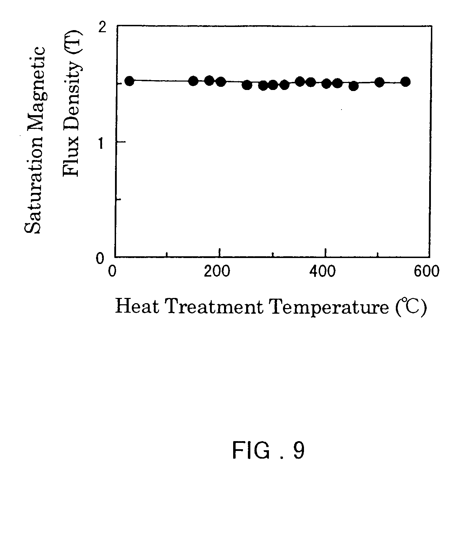

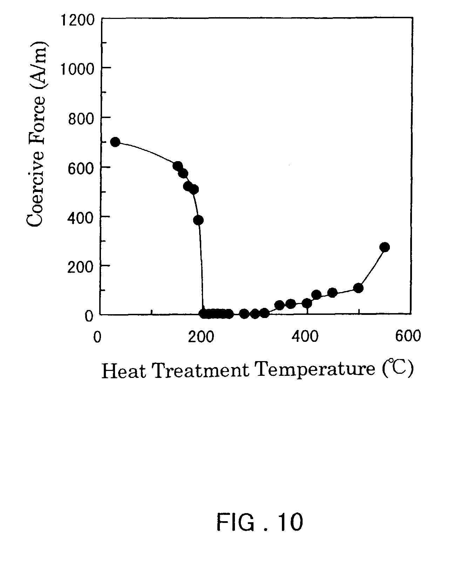

FIGS. 9 and 10 are graphs showing a change in the saturation magnetic flux density and coercive force of the $Fe_{70.5}Hf_{3.5}Pt_{8.5}N_{17.5}$ thin film with respect to the heat treatment.

As shown in FIG. 9, the saturation magnetic flux density obtains approximately constant values of 1.5 to 1.6 T from the state just after the deposition to the heat treatment at 550°C.

In addition, as shown in FIG. 10, the coercive force in the state just after the deposition obtains a large value of about 700 A/m. However, as the heat treatment temperature rises, the coercive force is gradually decreased, and the coercive force is abruptly decreased due to the heat treatment at 200°C and obtains a small value of not more than 1 A/m. This low value of the coercive force is maintained up to 320°C. Further, as the heat treatment temperature rises, the coercive force is gradually increased in a temperature range higher than 320°C, but the low coercive force of 28 A/m is obtained even at the heat treatment temperature of 350°C.

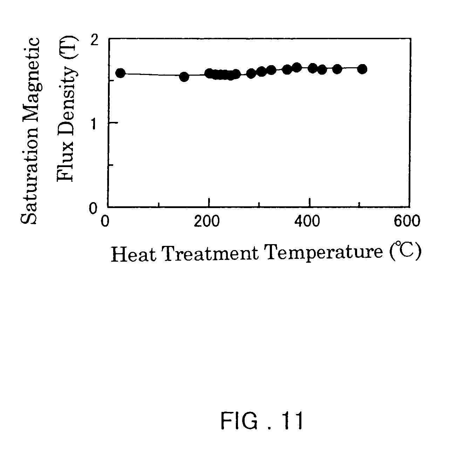

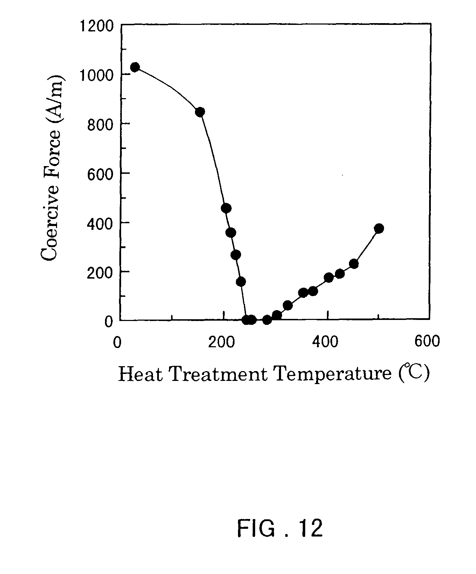

FIGS. 11 and 12 are graphs showing a change in the saturation magnetic flux density and coercive force of the $Fe_{75.5}Hf_4Pt_5N_{15.5}$ with respect to the heat treatment temperature.

As shown in FIG. 11, the saturation magnetic flux density obtains approximately constant values of 1.55 to 1.65 T from the state just after the deposition to the heat treatment at 500°C.

In addition, as shown in FIG. 12, the coercive force in the state just after the deposition obtains a large value of about 1020 A/m. However, as the heat treatment temperature rises, the coercive force is gradually decreased, and the coercive force is abruptly decreased due to the heat treatment at 240°C and obtains a small value of not more than 1 A/m. This low value of the coercive force is maintained up to 280°C. Further, as the heat treatment temperature rises, the coercive force is gradually increased in a temperature range higher than 280°C, but the low coercive force of 46 A/m is obtained even at the heat treatment temperature of 300°C.

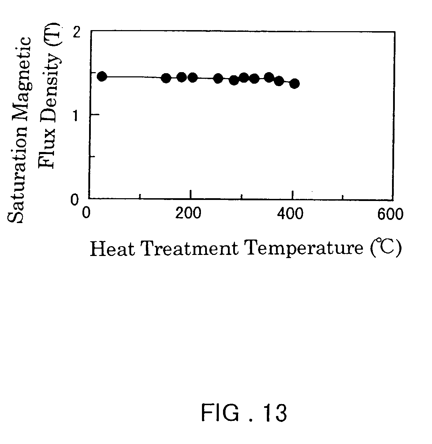

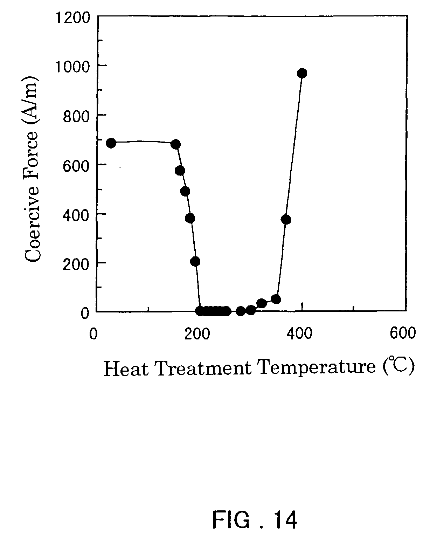

FIGS. 13 and 14 are graphs showing changes in the saturation magnetic flux density and coercive force of the $Fe_{73.5}Hf_4Pt_5N_{17.5}$ thin film with respect to the heat treatment.

As shown in FIG. 13, the saturation magnetic flux density obtains approximately constant values of 1.4 to 1.45 T from the state just after the deposition to the heat treatment at 400°C.

In addition, as shown in FIG. 14, the coercive force just after the deposition obtains a large value of about 680 A/m. However, as the heat treatment temperature rises, the coercive force is gradually decreased, and the coercive force is abruptly decreased due to the heat treatment at 200°C and obtains a small value of not more than 1A/m. This low value of the coercive force is maintained up to 280°C. Further, as the heat treatment temperature rises, the coercive force is abruptly increased in a temperature range higher than 350°C.

Results of X-ray diffraction of these Fe-Hf-Pt-N thin films are shown below.

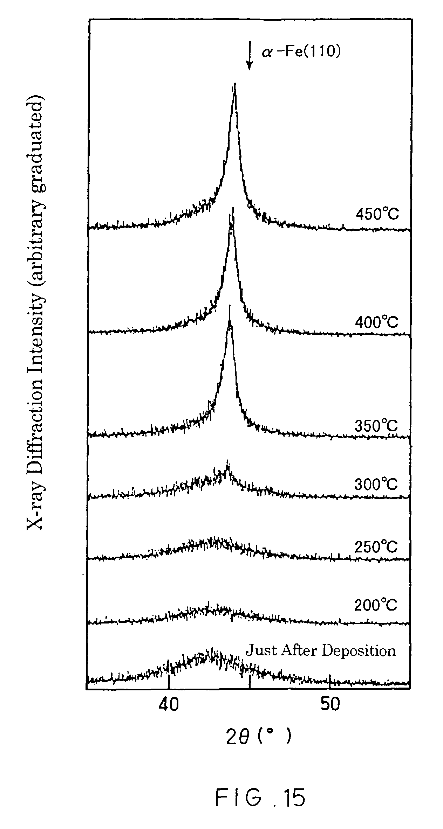

The changes in the X-ray diffraction patterns with respect to the heat treatment temperature are shown in FIGS. 15, 16, 17 and 18 in the order of the $Fe_{72}Hf_4Pt_{8.5}N_{15.5}$, $Fe_{70.5}Hf_{3.5}Pt_{8.5}N_{17.5}$, $Fe_{75.5}Hf_4Pt_5N_{15.5}$, $Fe_{73.5}Hf_4Pt_5N_{17.5}$ thin films. In the diagrams, arrows show peak positions on a (110) surface of $\alpha$-Fe.

As shown in FIGS. 15, 16, 17 and 18, in all the Fe-Hf-Pt-N thin films, the peak of $\alpha$-Fe which appears just after the heat treatment at a high temperature is observed on a low angle side from the peak position of $\alpha$-Fe represented by the arrow.

This means that a crystal lattice is expanded in $\alpha$-Fe which appears in the Fe-Hf-Pt-N thin film compared with pure iron.

As shown in FIG. 15, in the $Fe_{72}Hf_4Pt_{8.5}N_{15.5}$ thin film, a broad diffraction peak is observed in the heat treatment at 200 to 250°C where the coercive force of not more than 1 A/m can be obtained, and an amorphous phase is obtained.

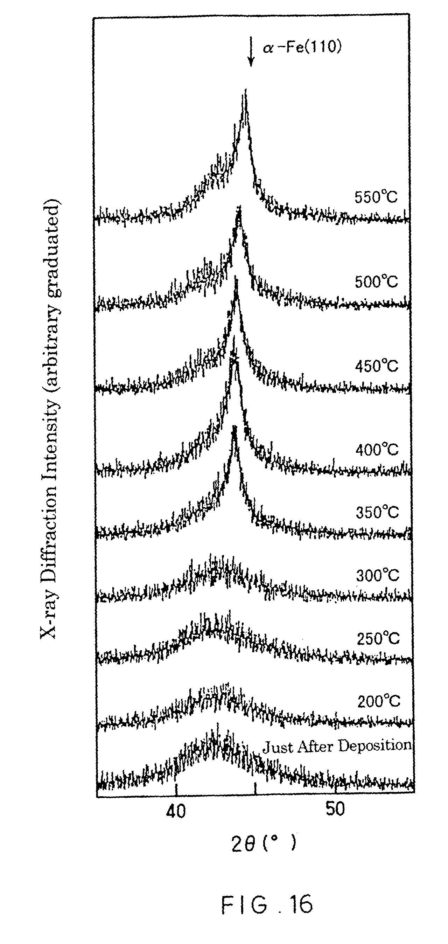

As shown in FIG. 16, in the $Fe_{70.5}Hf_{3.5}Pt_{8.5}N_{17.5}$ thin film, a broad diffraction peak is observed in the heat treatment at 200 to 250°C where the coercive force of not more than 1 A/m can be obtained, and an amorphous phase is obtained.

In addition, an average crystal particle diameter of $\alpha$-Fe after the heat treatment at 350°C where the low coercive force of 28 A/m can be obtained was calculated based on the result of the X-ray diffraction according to the Debye-Scherrer expression and determined to be about 7.5 nm. Thus a crystallite was obtained.

Therefore, the satisfactory soft magnetic (low coercive force) is realized in the amorphous phase and/or crystallite phase.

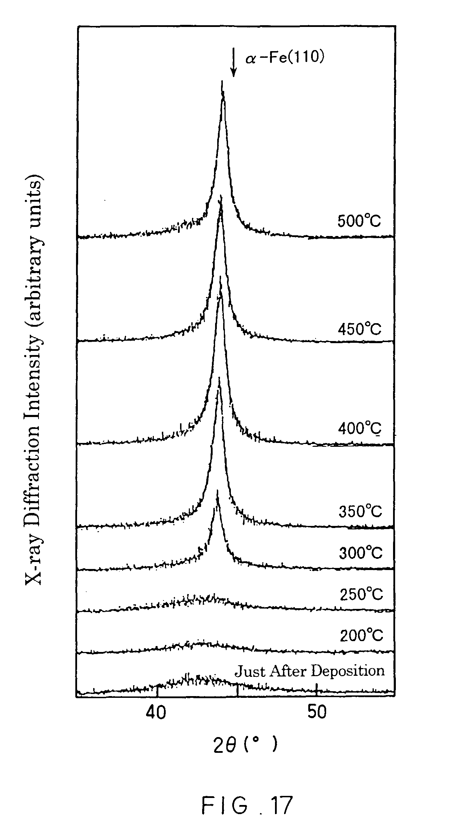

As shown in FIG. 17, in the $Fe_{75.5}Hf_4Pt_5N_{15.5}$ thin film, an amorphous phase is obtained in the heat treatment at 240 to 280°C where the low coercive force of not more than 1 A/m can be obtained.

In addition, an average crystal particle diameter of $\alpha$-Fe after the heat treatment at 300°C where the low coercive force of 46 A/m can be obtained was calculated based on the result of the X-ray diffraction according to the Debye-Scherrer expression and determined to be about 10 nm. Thus a crystallite was obtained.

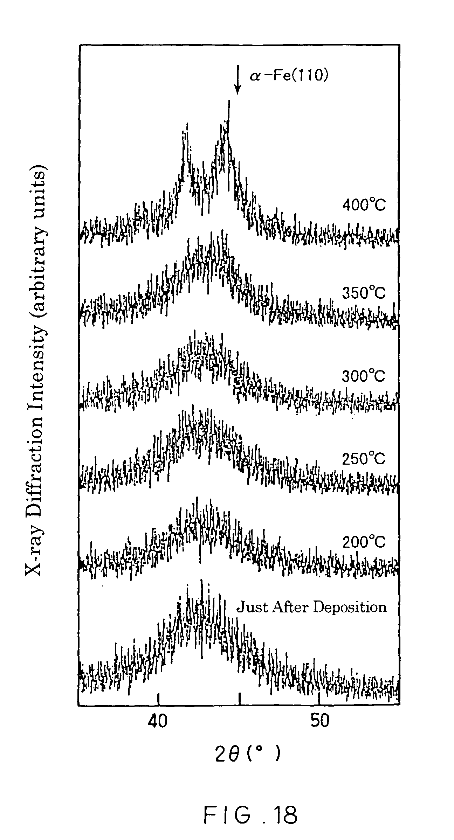

As shown in FIG. 18, in the $Fe_{73.5}Hf_4Pt_5N_{17.5}$ thin film, an amorphous phase is obtained in the heat treatment at 200 to 280°C where the low coercive force of not more than 1 A/m can be obtained.

In the heat treatment at 400°C where the soft magnetic property is deteriorated, in addition to the peak of $\alpha$-Fe, a diffracted ray of FePt appears in a vicinity of $2\theta = 41.5°$ and a diffracted ray of nitride of Hf appears in a vicinity of $2\theta = 39°$, i.e. a phase isolation occurs.

Here, the present embodiment described the Fe-Hf-Pt-N thin film, but the same effect can be obtained also in a soft magnetic film that contains Fe as a main component and includes N and M (M is at least one kind of element selected from 4A-group element, 5A-group element and 6A-group element) and at least one of element Pt or Pd.

In addition, the same effect can be obtained also in a soft magnetic thin film that contains Fe as a main component and includes M and X (X is at least one selected from B, C, O and N), and in a soft magnetic thin film that contains Fe as a main component and includes M, X and Y (Y is at least one selected from Pt and Pd).

(Embodiment 2)

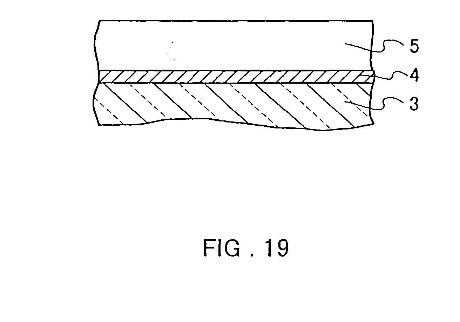

There will be described below a soft magnetic film including the above soft magnetic thin film with reference to FIG. 19. FIG. 19 is a cross-section of the soft magnetic film according to the present embodiment. As shown in FIG. 19, an Si thin film 4 of 50 nm was formed on Si and Ti-Mg-Ni-O ceramic substrate 3, and an Fe-Hf-Pd-N thin film 5 having a thickness of 1 μm was prepared on the Si thin film 4 according to the reactive sputtering method similarly to the embodiment 1. The composition of the thin film is such that the amount of Fe is 78 atomic %, Hf is 8 atomic %, Pd is 1 atomic % and N is 13 atomic %. The prepared Fe-Hf-Pd-N thin film 5 underwent heat treatment at 300°C for 1 hour in a vacuum of not more than $1 \times 10^{-3}$ Pa in a static magnetic field of 48 kA/m. A coercive force in the hard magnetization direction of the soft magnetic film having a double-layered structure where the Fe-Hf-Pd-N thin film 5 was formed on the Si thin film 4 was compared with that of a single-layered Fe-Hf-Pd-N thin film ($Fe_{78}Hf_8Pd_1N_{13}$) having a thickness of 1 μm, and they are shown in Table 1. Here, in Table 1, the case of using Si as a substrate is compared with the case of using the above-mentioned ceramics as a substrate.

(Table 1)

| Substrate | Single-layered film | Double-layered film |
| --- | --- | --- |
| Si | 1 A/m | 1 A/m |
| Ceramics | 32 A/m | 1 A/m |

As shown in Table 1, the coercive force of the single-layered Fe-Hf-Pd-N thin film formed on the Si substrate shows a small value of 1 A/m which is equivalent to the value of the coercive force of the soft magnetic film having a double-layered structure where the Si thin film was formed on the Si substrate and the Fe-Hf-Pd-N thin film was formed thereon.

However, the coercive force of the single-layered Fe-Hf-Pd-N soft magnetic thin film formed on the ceramics substrate is 32 A/m, but when a soft magnetic film having a double-layered structure was formed in such a manner that the Si thin film was formed on the ceramics substrate and the Fe-Hf-Pd-N thin film was formed on the Si thin film, the low coercive force of 1 A/m, which is equivalent to that of the single-layered Fe-Hf-Pd-N thin film formed on the Si substrate, was obtained.

The realization of the excellent soft magnetic properties, which can be obtained in the soft magnetic film having a double-layered structure where the Si thin film was formed on the substrate and the Fe-Hf-Pd-N thin film was formed thereon, is not limited to the case of using the ceramics substrate, and thus the same effect is produced in a case where a substrate material is glass, an organic film or the like.

In addition, the thickness of the Si thin film is not limited to 50 nm, and thus the same effect is produced in the case of a desired film thickness.

Here, the present embodiment described the Fe-Hf-Pd-N thin film, but the same effect can be obtained also in a soft magnetic thin film that contains Fe as a main component and includes M and N and at least one of Pt or Pd.

(Embodiment 3)

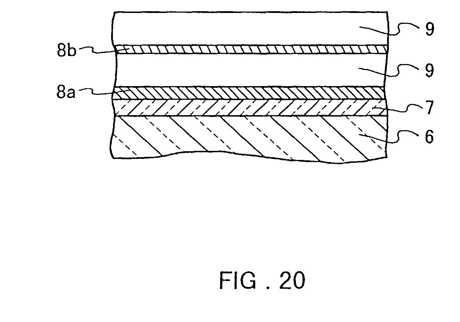

There will be described below another form of the soft magnetic film of the present invention with reference to FIG. 20. FIG. 20 is a cross-section of the soft magnetic film according to the present embodiment. As shown in FIG. 20, an $Al_2O_3$ thin film 7 was formed on an $Al_2O_3$-TiC substrate 6, and an Si thin film 8a having a thickness of 50 nm was formed thereon. An Fe-Hf-Pd-N thin film 9 having a thickness of 0.5 $\mu$m was formed on the Si thin film 8a, and an Si thin film 8b of 5 nm was formed thereon and an Fe-Hf-Pd-N thin film 9 of 0.5 $\mu$m was formed thereon. The multi-layered soft magnetic thin film prepared in such a manner underwent heat treatment at 250°C for 1 hour in a vacuum of not more than $1 \times 10^{-3}$ Pa and in a static magnetic field of 48 kA/m.

The composition of the Fe-Hf-Pd-N thin film 9 is the same as that in embodiment 2.

A coercive force of the soft magnetic film in a hard magnetization direction was 2 A/m. When compared with the coercive force of 58 A/m in the case where an $Al_2O_3$ thin film was formed on an $Al_2O_3$-TiC substrate and a single-layered Fe-Hf-Pd-N thin film of 1 $\mu$m was formed thereon, the soft magnetic property of the multi-layered soft magnetic film was greatly improved.

Here, the present embodiment described the Fe-Hf-Pd-N thin film, but the same effect can be obtained in a soft magnetic thin film that contains Fe as a main component and includes N and M and at least one of Pt or Pd.

Here, a small quantity of at least one element selected from Ar, O, C, Cr, Al, Si, Ru and Rh may be included in the soft magnetic thin film according to the embodiments 1 through 3 as long as the film serves the object of the present invention.

(Embodiment 4)

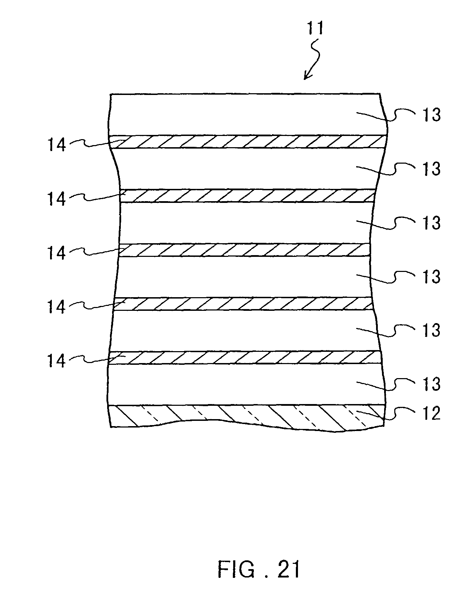

There will be described below a soft magnetic multi-layered film according to the present embodiment of the present invention with reference to FIGS. 21 through 24.

FIG. 21 is a cross-section of a soft magnetic multi-layered film according to one embodiment of the present invention. A soft magnetic multi-layered film 11 is basically composed in such a manner that a soft magnetic film 13 and a non-magnetic film 14 are layered alternately. The soft magnetic film 13 is at least one kind of a soft magnetic thin film where the single-layered Fe-M-(Pt,Pd)-N thin film shown in FIG. 1 was formed on the surface of the substrate 12, and a double-layered soft magnetic film where the Fe-M-(Pt,Pd)-N thin film was formed on the Si thin film shown in FIG. 19, and a multi-layered soft magnetic film shown in FIG. 20 where a plurality of double-layered soft magnetic films are formed. The number of layered films and the thickness of the respective films are not particularly limited, and thus they are set suitably according to a required property.

The soft magnetic multi-layered film 11 may be structured in such a manner that the thicknesses of the soft magnetic films 13 and/or the non-magnetic films 14 are different from each other.

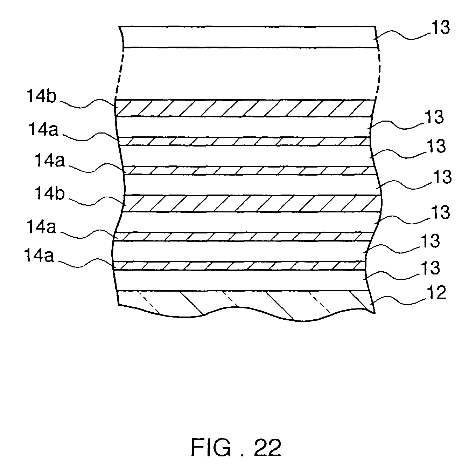

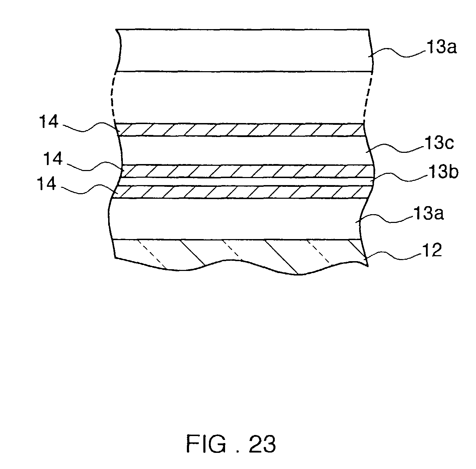

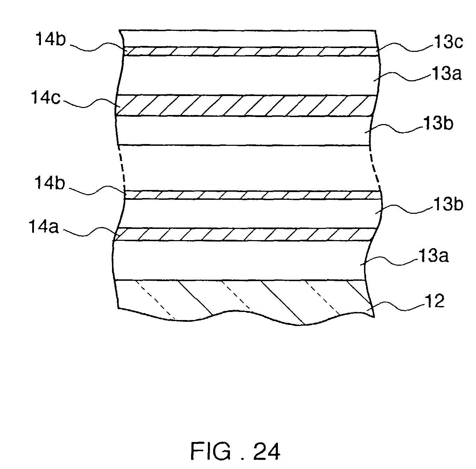

FIG. 22 shows a form in which the non-magnetic film 14 includes two kinds of films whose thicknesses are different from each other, namely, a non-magnetic film 14a having a thickness of 0.5 to 50 nm and a non-magnetic film 14b having a thickness of 50 to 500 nm. Moreover, FIG. 23 shows a form in which the soft magnetic film 13 includes three kinds of soft magnetic films 13a, 13b and 13c whose thicknesses are different from each other. FIG. 24 shows a form in which the soft magnetic film 13 and the non-magnetic film 14 have different thicknesses. Here, in FIGS. 22 through 24, symbols a, b and c show that the thicknesses of the films to which the respective symbols are given are the same. Moreover, in these forms, a preferable thickness of the soft magnetic film 13 is 5 to 5000 nm.

The soft magnetic film 13 can be formed with the radio-frequency diode sputtering device according to the reactive sputtering method in such a manner that alloy is used as a target and $N_2$ gas is introduced into Ar gas. The nitrogen contained in the soft magnetic film 13 can be optimized by adjusting a partial pressure of the $N_2$ gas in an atmosphere.

Here, as the non-magnetic film 14, $SiO_2$, $Al_2O_3$, AlN, BN, TiN, SiC, Cu, C or Ti, or a nitride, an oxide or a carbide of Ta, Nb, Zr or Hf, can be used. It is preferable that the non-magnetic film and the Si thin film are formed and laminated by the radio-frequency sputtering method as the soft magnetic film 13 successively with the soft magnetic film 13.

(Embodiment 5)

There will be described below a magnetic device according to the present embodiment of the present invention using the soft magnetic film or soft magnetic multi-layered film described in the above embodiments.

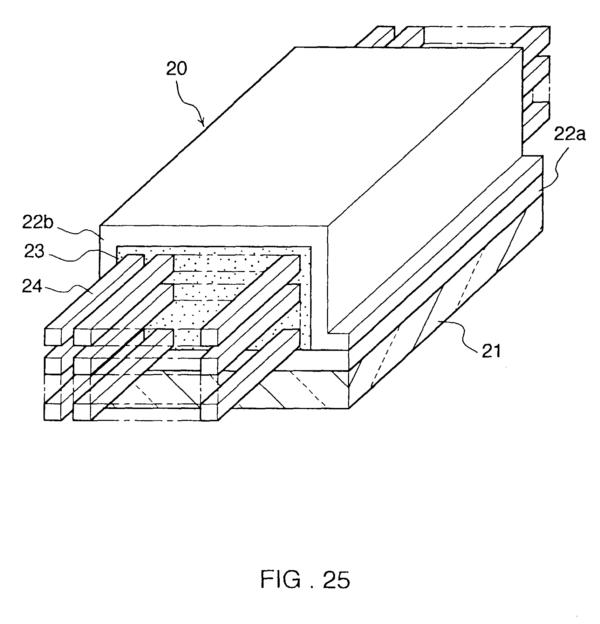

FIG. 25 is a perspective view showing a noise filter, which is one form of the magnetic device of the present invention. In the noise filter 20, a plurality of bar-shaped conductors 24 composed of conductors of Cu, Al or the like are arranged in an insulator 23 of $SiO_2$ or the like longitudinally and laterally keeping uniform intervals so that a composite is formed on a lower soft magnetic film 22a formed on a non-magnetic substrate 21. The composite is surrounded by an upper soft magnetic film 22b, which contact respectively with an upper surface and both side surfaces of the insulator 23, and the lower soft magnetic film 22a.

The lower soft magnetic film 22a and the upper soft magnetic film 22b may be a single-layered Fe-M-(Pt,Pd)-N soft magnetic thin film, a double-layered soft magnetic film where an Fe-M-(Pt,Pd)-N thin film was formed on an Si thin film or a soft magnetic film where a plurality of double-layered soft magnetic films are laminated. Moreover, they may be a soft magnetic multi-layered film composed in such a manner that the soft magnetic (thin) film and a non-magnetic film are laminated alternatively.

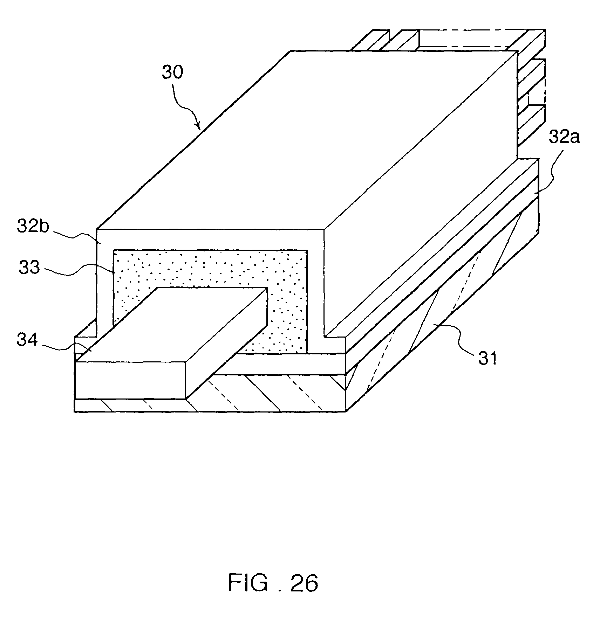

FIG. 26 shows another form of the noise filter. As shown in FIG. 26, a noise filter 30 including one conductor 34 is structured in such a manner that the conductor 34 and an insulator 33 are surrounded by a lower soft magnetic film 32a formed on a surface of a non-magnetic substrate 31 and an upper soft magnetic film 32b that contacts with an upper surface and both side surfaces of the insulator 33.

The lower soft magnetic film 32a and the upper soft magnetic film 32b may be a single-layered Fe-M-(Pt,Pd)-N soft magnetic thin film, or a double-layered soft magnetic film where an Fe-M-(Pt,Pd)-N thin film was formed on an Si thin film, or a soft magnetic film where a plurality of double-layered soft magnetic film are laminated. Moreover, they may be a soft magnetic multi-layered film structured in such a manner that the soft magnetic (thin) film and a non-magnetic film are laminated alternately.

A composition range of the Fe-M-(Pt,Pd)-N thin film composing such a soft magnetic film is preferably such that N is 1 to 35 atomic %, M is 0.1 to 20 atomic %, at least one of Pt or Pd is 0.1 to 20 atomic % and the rest is Fe.

As mentioned above, the noise filter, which is one form of the magnetic device of the present invention, includes the bar-shaped conductor 34, the insulator 33 for covering the conductor 34, the lower soft magnetic thin film 32a and the upper soft magnetic film 32b that are provided so as to surround the surface of the insulator 33 and sandwich the insulator.

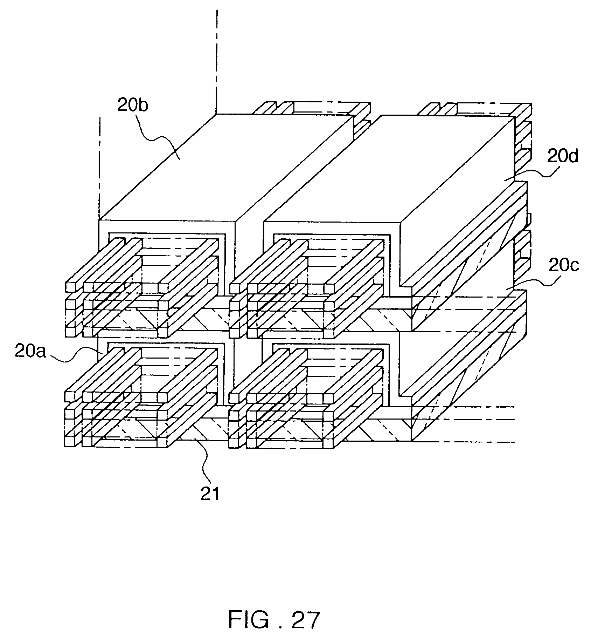

Here, as shown in FIG. 27, the noise filter in the embodiment 5 can be used in a form in which a plurality of noise filters 20a through 20d are arranged on the non-magnetic substrate 21 longitudinally and laterally.

An electromagnetic interference restrainer according to one form of the magnetic device is composed of a soft magnetic multi-layered film that is structured in such a manner that a single-layered Fe-M-(Pt,Pd)-N thin film is formed on a substrate made of an organic film such as polyimide, a double-layered soft magnetic film, where an Fe-M-(Pt,Pd)-N thin film was formed on an Si thin film, is formed, a soft magnetic film where a plurality of double-layered soft magnetic film were laminated, or the soft magnetic (thin) film and a non-magnetic film are laminated alternatively.

The preferable composition range of the Fe-M-(Pt,Pd)-N thin film composing such a soft magnetic film is the same as the above.

A double-layered soft magnetic film, where an Si thin film of 50 nm was formed on a polyimide film and an $Fe_{78}Hf_8Pd_1N_{13}$ thin film of 1 μm was formed on the Si thin film, was prepared by the reactive sputtering method similarly to the aforementioned embodiments. The prepared soft magnetic film underwent heat treatment at 300°C for 1 hour in a vacuum of not more than $1 \times 10^{-3}$ Pa in a static magnetic field of 48 kA/m.

When the electromagnetic interference restrainer composed of the soft magnetic film is wound around a cable for connecting parts-mounted print circuit substrates used in a digital audio device, an electromagnetic wave noise in a vicinity of the frequency of 200 MHz is reduced by about 5 to 9 dB.

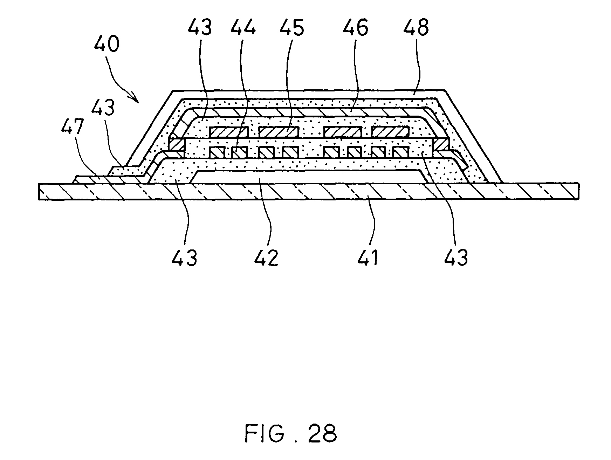

FIG. 28 shows a thin film transformer, which is one form of the magnetic device of the present invention. The thin film transformer 40 has a laminated structure such that a lower soft magnetic film 42, an insulating film 43, a secondary coil 44, an insulating film 43, a primary coil 45, an insulating film 43, a conductor 46, an insulating film 43 and an upper soft magnetic film 48 are formed in this order on a surface of a non-magnetic substrate 41 made of glass, Si wafer or the like. This laminated structure is substantially covered by the upper soft magnetic film 48 and a terminal 47 is extended to the outside between the upper soft magnetic film 48 and the non-magnetic substrate 41. Here, the secondary coil 44, the primary coil 45 and the conductor 46 are composed of a conductor material such as Cu, and the insulating film 43 is composed of $SiO_2$ or the like. Moreover, the primary coil 45 and the secondary coil 44 are structured so as to be wound up in a horizontal direction (parallel direction with the laminated surface), and the winding-up ratio is set to a predetermined value.

The thin film transformer 40, which is one form of the magnetic device of the present invention, has the primary coil 45 and the secondary coil 44 wound up in the plane parallel with the laminated surface via the insulating film 43, and the lower soft magnetic film 42 and upper soft magnetic film 48 arranged so as to sandwich the primary coil 45 and secondary coil 44 via the insulating film 43.

The lower soft magnetic film 42 and upper soft magnetic film 48 shown in FIG. 28 form a magnetic core of the thin film transformer, and they may be a single-layered Fe-M-(Pt,Pd)-N soft magnetic thin film, or a double-layered soft magnetic film where an Fe-M-(Pt,Pd)-N thin film was formed on an Si thin film, or a soft magnetic film where a plurality of double-layered soft magnetic film are laminated like the aforementioned embodiments. Moreover, they may be a soft magnetic multi-layered film formed by laminating the soft magnetic (thin) film and the non-magnetic film alternately.

A preferable composition range of the Fe-M-(Pt,Pd)-N thin film composing such a soft magnetic film is the same as the above one.

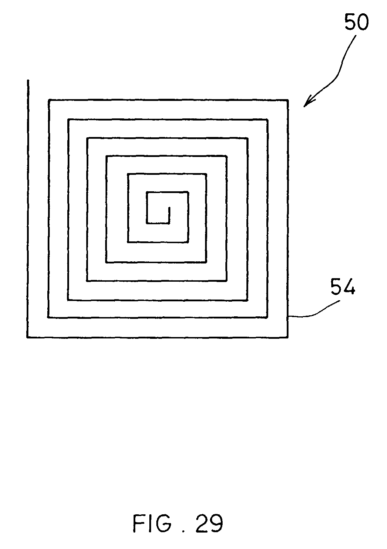

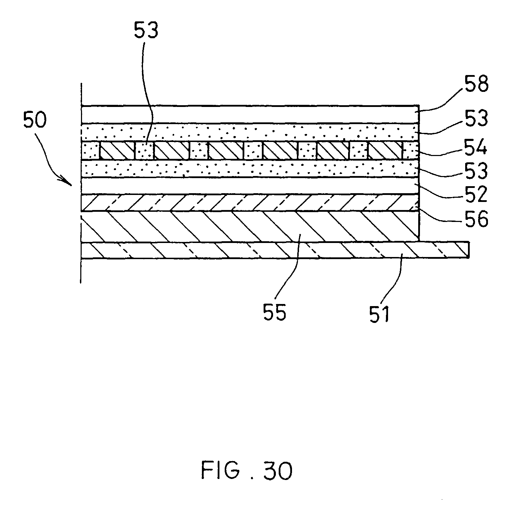

FIGS. 29 and 30 show one form of a thin film inductor. The thin film inductor is on an Si chip in an Si chip-mounted microreactor. FIG. 29 is a plan view showing a certain single conductor film of the thin film inductor. FIG. 30 is a cross-section of a thin film inductor 50 having a conductor film 54 of FIG. 29. In FIG. 30, the thin film inductor 50 has a laminated structure such that an $SiO_2$ film 56, a lower soft magnetic film 52, an insulating film 53 made of $SiO_2$ or the like, a conductor film 54 made of Cu, Al or the like having a pattern of winding up in the direction of a laminated surface, and an upper soft magnetic film 58 are formed in this order on an Si chip 55 on an IC package 51.

The thin film inductor 50, which is one form of the magnetic device of the present invention, has the conductor film 54 as a thin film coil wound up on a surface parallel with the laminated surface, and the lower soft magnetic film 52 and upper soft magnetic film 58 arranged so as to sandwich the conductor film 54, namely, the layered structure.

In addition, the soft magnetic films 52 and 58 form a magnetic core of the thin film inductor 50, and they may be a single-layered Fe-M-(Pt,Pd)-N soft magnetic thin film, a double-layered soft magnetic film where an Fe-M-(Pt, Pd)-N thin film was formed on an Si thin film, or a soft magnetic film where a plurality of double-layered soft magnetic films were laminated like the above embodiments. The lower soft magnetic film 52 and upper soft magnetic film 58 may be a soft magnetic multi-layered film where the soft magnetic film and non-magnetic film were laminated.

A composition range of the Fe-M-(Pt,Pd)-N thin film composing such a soft magnetic film is also the same as the above one.

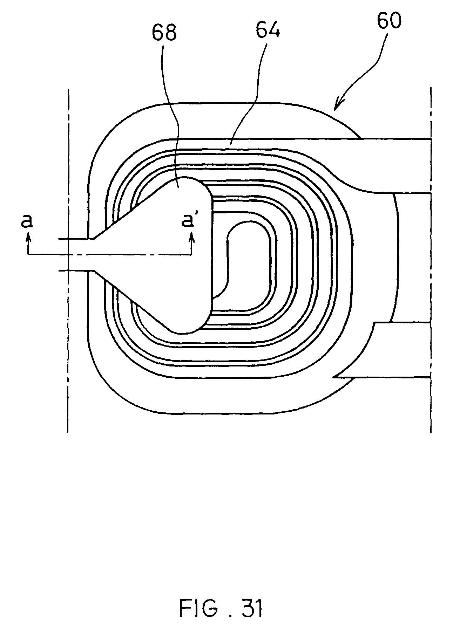

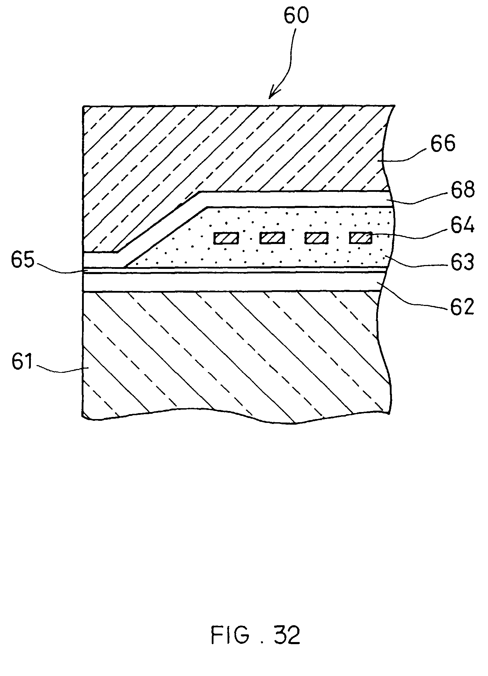

FIGS. 31 and 32 show a thin film magnetic head, which is one form of the magnetic device of the present invention. FIG. 31 is a plan view of the thin film magnetic head. FIG. 32 is a cross-section of the thin film magnetic head 60 shown in FIG. 31 taken along line a-a'. The thin film magnetic head 60 is structured in such a manner that a lower soft magnetic film 62, a gap layer 65 made of $Al_2O_3$, $SiO_2$ or the like, an insulating layer 63 made of $SiO_2$ or the like, a thin film coil 64 made of copper or the like, an upper soft magnetic film 68, and a protective layer 66 made of $Al_2O_3$ or the like are formed in this order on a surface of an insulating substrate 61 made of $Al_2O_3$-TiC or the like.

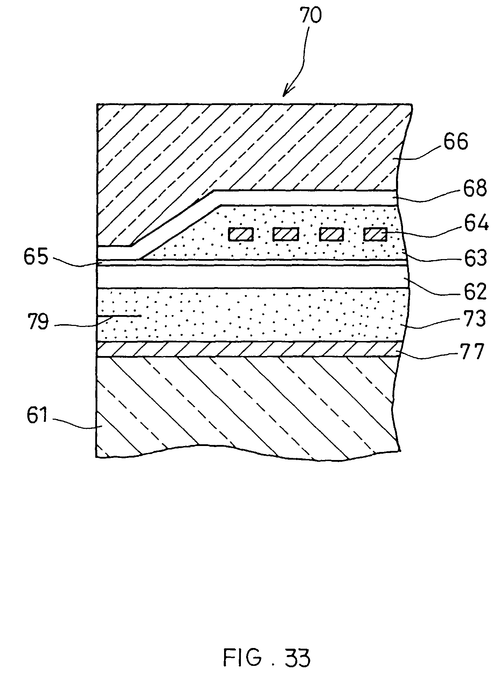

In addition, FIG. 33 shows another form of the thin film magnetic head. A thin film magnetic head 70 is different from the thin film magnetic head 60 shown in FIG. 32 in that an insulating layer 73 is put between a lower soft magnetic film 62 and a magnetic shield core layer 77, and a magnetoresistive element 79 is put into a part of the insulating layer 73. The thin film magnetic head 70 is structured so that a shielding-type magnetoresistive head (hereinafter, "MR head") is mounted as a playback-only head, and the magnetoresistive element 79 is magnetically shielded by the lower soft magnetic film 62 and the magnetic shield core 77. The magnetoresistive element 79 is made of a Permalloy thin film, or a magnetoresistive material such as CoO/NiFe/Cu/NiFe, CoMnB/Co/Cu/Co or the like. Here, the shielding-type head was described, but a yoke-type MR head may be used.

As mentioned above, the thin film magnetic heads 60 and 70, which are the forms of the magnetic device of the present invention, has the thin film coil 64 wound up in the direction of the laminated surface, and the soft magnetic films 62 and 68 arranged to sandwich the thin film coil 64 via the insulating layer 63.

In addition, the soft magnetic films 62 and 68 form the magnetic core of the thin film magnetic heads 60 and 70, and they may be a single-layered Fe-M-(Pt,Pd)-N soft magnetic thin film or a double-layered soft magnetic film where an Fe-M-(Pt,Pd)-N thin film was formed on an Si thin film or a soft magnetic film where a plurality of double-layered soft magnetic films are laminated like the above embodiments. Moreover, they may be a soft magnetic multi-layered film where the soft magnetic (thin) film and non-magnetic film are laminated alternatively.

A composition range of the Fe-M-(Pt,Pd)-N thin film composing such a soft magnetic film is also the same as the above one.

Here, the present embodiment described the thin film magnetic head, but the present invention is not limited to this. Therefore, as the magnetic head, a laminated type, a metal-in-gap (MIG) type or a main pole exciting type magnetic head or magnetic heads with other forms may be used.

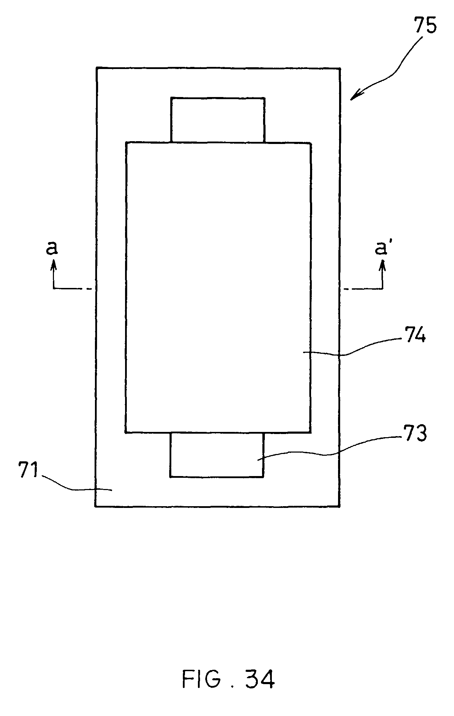

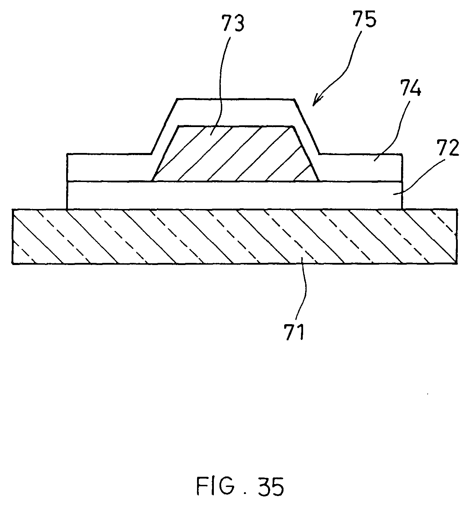

FIGS. 34 and 35 show one form of a magnetic impedance device. FIG. 34 is a plan view of the magnetic impedance device, and FIG. 35 is a cross-section of the magnetic impedance device 75 shown in FIG. 34 taken along line a-a'. As shown in FIGS. 34 and 35, the magnetic impedance device 75 is structured in such a manner that a conductor 73 is surrounded by a lower soft magnetic film 72 formed on a surface of a non-magnetic substrate 71, and an upper soft magnetic film 74 that contacts with an upper surface and both side surfaces of a bar-shaped non-magnetic conductor 73 made of Cu or the like.

The lower soft magnetic film 72 and the upper soft magnetic film 74 shown in FIGS. 34 and 35 form the magnetic core of the magnetic impedance device, and they may be a single-layered Fe-M-(Pt,Pd)-N soft magnetic film, or a double-layered soft magnetic film where an Fe-M-(Pt,Pd)-N thin film was formed on an Si thin film, or a soft magnetic film where a plurality of double-layered soft magnetic films are laminated like the aforementioned embodiments. Moreover, they may be a soft magnetic multi-layered film where the soft magnetic (thin) film and non-magnetic film are laminated alternately.

A composition range of the Fe-M-(Pt,Pd)-N thin film composing such a soft magnetic film is also the same as the above one.

In addition, the magnetic device where the magnetic core includes the soft magnetic film and soft magnetic multi-layered film is used in a liquid crystal television antenna, electromagnetic interference restrainer, noise filter, pulse motor, choke coil, transformer, inductor, magnetic impedance device, magnetic head or the like.

There will be further detailed below the electromagnetic interference restrainer of the present invention.

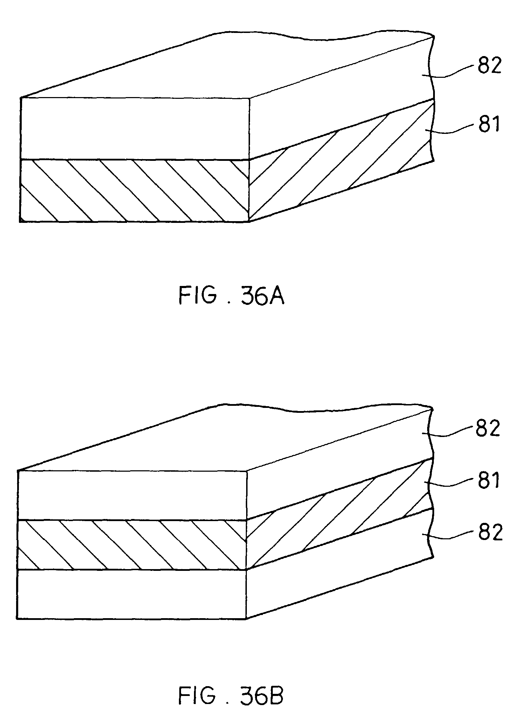

FIG. 36 is a perspective view showing an electromagnetic interference restrainer composed of two kinds of layers, i.e., the soft magnetic film and non-magnetic insulating film. FIG. 36A shows a structure in which a non-magnetic insulating film 82 is arranged on one surface of a soft magnetic film 81, and FIG. 36B shows a structure in which the non-magnetic insulating films 82 are arranged on both surfaces of the soft magnetic film 81.

The non-magnetic insulating film supports the whole electromagnetic interference restrainer and electrically insulates soft magnetic films, which are wound around a cable spirally. Moreover, the soft magnetic film magnetically absorbs a noise.

The soft magnetic film 81 is a single-layered soft magnetic thin film that has a composition containing Fe as a main component and including M and X (M is at least one kind of 4A-group, 5A-group or 6A-group element such as Zr, Hf, Ti, Nb, Ta, V, Mo, W or Cr, and X is at least one of B, C, N or O), or a soft magnetic thin film which has a composition main containing Fe and including M, X and Y (Y is at least one of Pt or Pd). Moreover, the soft magnetic film 81 may be a soft magnetic thin film which is formed on an Si thin film so as to have a double-layered structure, or a soft magnetic film where a plurality of double-layered soft magnetic films are laminated.

In addition, the soft magnetic film 81 may be a soft magnetic multi-layered film where the soft magnetic film and non-magnetic film are laminated alternately. The number of laminated films and their thicknesses are not limited, and they are set suitably according to a required property.

In addition, the soft magnetic multi-layered film is formed so that the soft magnetic films and non-magnetic films have at least two kinds of thicknesses. As a result, the electromagnetic interference restrainer having the more excellent high frequency property can be provided.

Furthermore, the soft magnetic multi-layered film is constituted so as to have at least one layer whose direction showing high permeability in the plane of the soft magnetic films adjacent to each other via the non-magnetic film. As a result, unnecessary electromagnetic waves that enter in various directions at various angles can be absorbed.

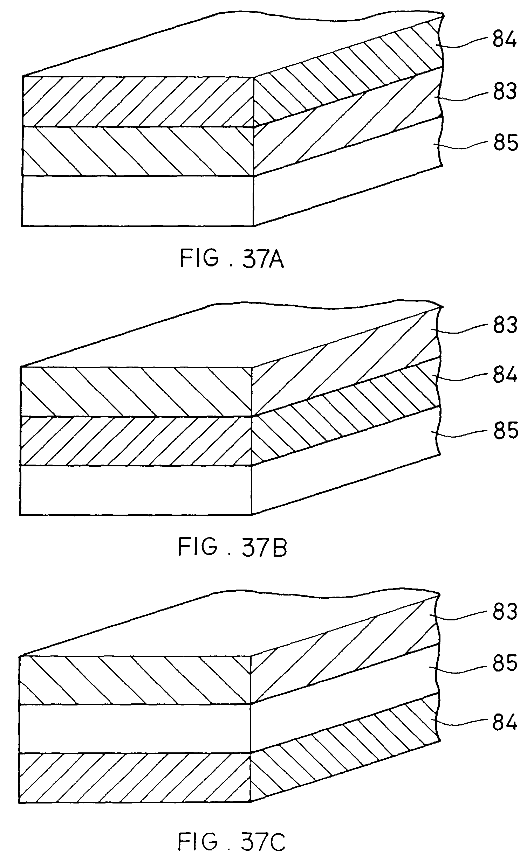

FIG. 37 is a perspective view showing a form of the electromagnetic interference restrainer composed of three kinds of layers of a soft magnetic film 83, a conductive film 84 and a non-magnetic insulating film 85. FIG. 37A shows a structure in which a conductive film 84 is provided on one surface of the soft magnetic film 83 and the non-magnetic insulating film 85 is provided on the other surface of the soft magnetic film 83. FIG. 37B shows a structure in which the soft magnetic film 83 is provided on one surface of the conductive film 84 and the non-magnetic insulating film 85 is provided on the other surface. FIG. 37C shows a structure in which the soft magnetic film 83 is provided on one surface of the non-magnetic insulating film 85 and the conductive film 84 is provided on the other surface.

The non-magnetic insulating film supports the whole electromagnetic interference restrainer and electrically insulates the soft magnetic films, which are wound around a cable spirally. Moreover, the conductive film electrically shields a noise, and the soft magnetic film magnetically absorbs a noise.

As the form of the electromagnetic interference restrainer composed of three kinds of layers of the soft magnetic film 83, the conductive film 84 and the non-magnetic insulating film 85, FIG. 37 shows the electromagnetic interference restrainer having three structures shown of FIGS. 37A through 37C, but it is not limited to these three structures. For example, the non-magnetic insulating film may be provided on one surface or both surfaces of the restrainers of FIGS. 37A through 37C, and the conductive film may be provided on one surface both surface of the restrainers of FIGS. 37A through 37C.

The non-magnetic film composing the soft magnetic multi-layered film, and the non-magnetic insulating film 82 composing the electromagnetic interference restrainer shown in FIGS. 36A and 36B, and the non-magnetic insulating film 85 composing the electromagnetic interference restrainer shown in FIGS. 37A through 37C are made of $SiO_2$, $Al_2O_3$, AlN, BN, TiN, SiC, polyimide, Kapton, photo-resist, polyethylene naphthalate (PEN), polyethylene terephthalate (PET), C or Ti, or nitride, oxide or carbide of Ta, Nb, Zr or Hf.

The conductive film 84 composing the electromagnetic interference restrainer shown in FIGS. 37A through 37C is made of, for example, Cu, Al, Ag, Au, Pt, Sn, Cr, Zn, In or the like.

In addition, it is preferable that the soft magnetic film 81 in the electromagnetic interference restrainer shown in FIGS. 36A and 36B, and the soft magnetic film 83 in the electromagnetic interference restrainer shown in FIGS. 37A through 37C have a composition composed of at least one of the amorphous phase and the crystallite phase. Moreover the preferable composition range is such that M is 0.1 to 20 atomic %, X is 1 to 35 atomic %, Y is 0 to 20 atomic %, and the rest is Fe.

Here, the electromagnetic interference restrainers shown in FIGS. 36A and 36B and FIGS. 37A through 37C can be used regardless of their right and wrong sides.

In addition, at least one of the electromagnetic interference restrainers having the structures shown in FIGS. 36A and 36B and FIGS. 37A through 37C may be an electromagnetic interference restrainer where a plurality of layers are laminated.

When the electromagnetic interference restrainer mentioned above is wound around a cable, the effect as a noise filter can be obtained in the high-frequency bandwidth of not less than several hundred MHz, and simultaneously flexibility of the cable is maintained so that this structure can cope with size-reduction and lightening.

In addition, the electromagnetic interference restrainer can be arranged in a cable so that the filter and the cable can be produced integrally. As a result, a cost required for mounting the filter by a personnel is not required, and thus the cost can be reduced.

There will be further detailed below the electromagnetic interference restrainer mentioned above according to embodiments.

(Embodiment 6)

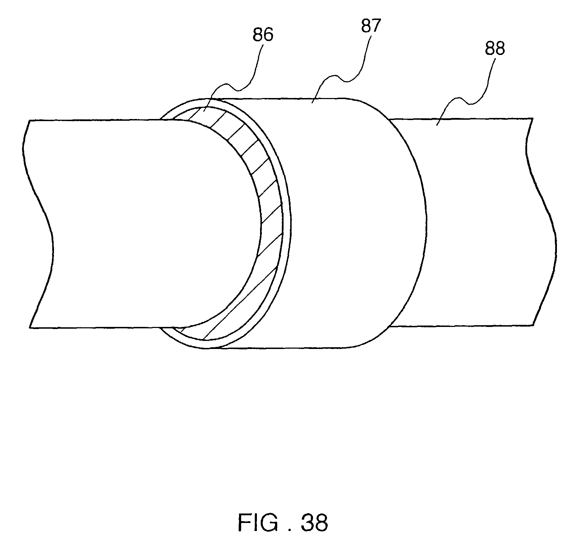

FIG. 38 is a diagram showing an example of mounting the electromagnetic interference restrainer of the present invention to the cable. In the first example of the electromagnetic interference restrainer, a double-layered soft magnetic film 87 was prepared by the reactive sputtering method in such a manner that an Si thin film of 50 nm was formed on a polyimide film 86 as a non-magnetic insulating substrate and a soft magnetic thin film having a thickness of 1 $\mu$m where the amount of Fe is 78 atomic %, Hf is 9 atomic % and N is 13 atomic % (hereinafter, shown as $Fe_{78}Hf_9N_{13}$) was formed on the Si thin film. The prepared magnetic film underwent the heat treatment at 300°C for 1 hour in a vacuum of not more than $1 \times 10^{-3}$ Pa in a static magnetic field of 48 kA/m.

In addition, in the second example of the electromagnetic interference restrainer, the double-layered soft magnetic film 87 was prepared by the reactive sputtering method in such a manner that an Si thin film of 50 nm was formed on the polyimide film 56 as the non-magnetic insulating substrate and a soft magnetic thin film having a thickness of 1 $\mu$m where the amount of Fe is 60 atomic %, Hf is 10 atomic % and O is 30 atomic % ($Fe_{60}Hf_{10}O_{30}$) was formed on the Si thin film.

Further, as the soft magnetic films of the third through fifth examples, the double-layered soft magnetic film 87, where soft magnetic thin films of $Fe_{78}Hf_8Pd_1N_{13}$, $Fe_{79}Zr_6C_4N_{11}$ and $Fe_{82}Ta_3Cr_2B_1N_{12}$ were formed, was prepared by the reactive sputtering method. These soft magnetic films also underwent the heat treatment at 300°C for 1 hour in a vacuum of not more than $1 \times 10^{-3}$ Pa in a static magnetic field of 48 kA/m.

The filter of the first example ($Fe_{78}Hf_9N_{13}$) of the electromagnetic interference restrainers was wound around an outside of a cable 88 for connecting the parts-mounted print circuit substrates of the digital audio device, an electromagnetic noise in a vicinity of the frequency 200 MHz was reduced by about 5 to 9 dB. The approximately similar effect could be obtained also in the second through fifth examples.

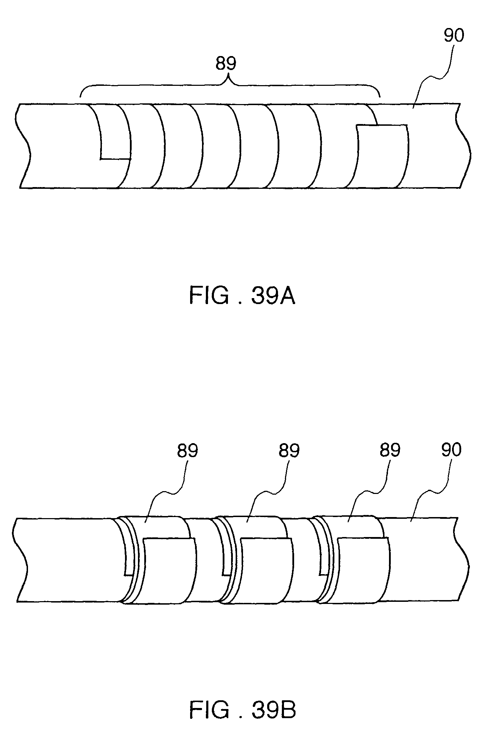

Next, FIG. 39 shows another example of mounting the electromagnetic interference restrainer to the cable. FIG. 39A shows a state in which an electromagnetic interference restrainer 89 is wound around a cable spirally, and FIG. 39B shows a state in which the electromagnetic interference restrainer 89 is wound around one position of the cable 90 in a superposed state.

The electromagnetic interference restrainer 89 may be wound at one portion, plural portions or the whole of the cable.

(Embodiment 7)

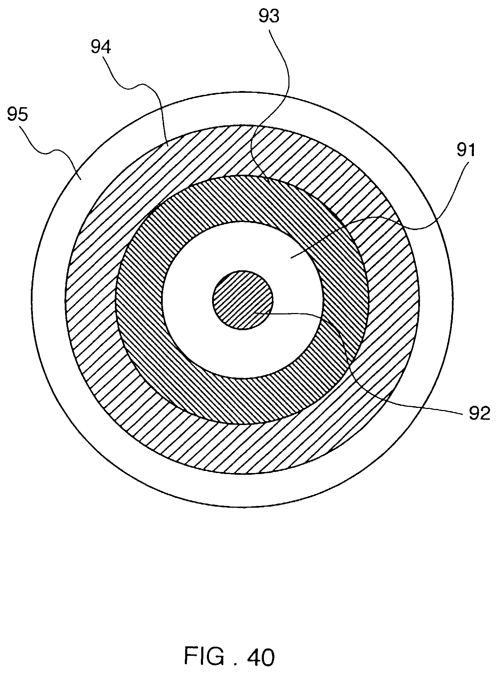

There will be described below the embodiment 7 where the electromagnetic interference restrainer of the present invention is contained in the cable by the winding method of embodiment 7 with reference to FIG. 40.

FIG. 40 is a cross-section of the cable in the case where the electromagnetic interference restrainer is contained in a coaxial cable in the present embodiment. A conductor 93 is arranged on the outside of a core 92 covered by an insulator coated film 91 made of polyethylene or the like, and an electromagnetic interference restrainer 94 of the present invention described in the embodiments 1 and 2 is arranged on its outside, and an insulator 95 made of polyethylene, vinyl chloride or the like is arranged on the outside of the electromagnetic interference restrainer 94.

(Embodiment 8)

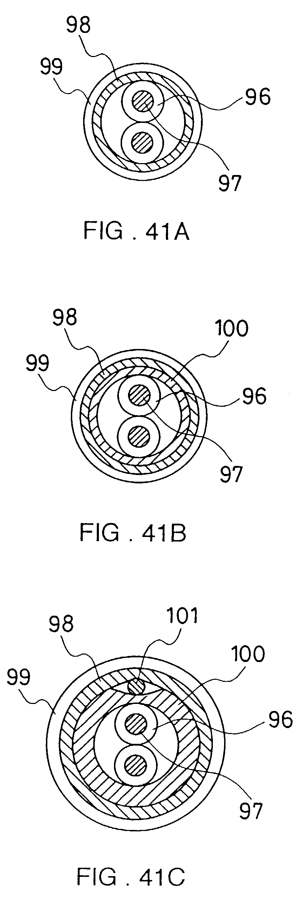

FIGS. 41A through 41C are cross-sections of a cable of embodiment 8. In FIG. 41A, an electromagnetic interference restrainer 98 of the present invention is arranged on the outside of a plurality of cores 97 coated with an insulator coated film 96 made of polyethylene or the like, and an insulator 99 made of polyethylene, vinyl chloride or the like is arranged on the outside of the electromagnetic interference restrainer 98, and the electromagnetic interference restrainer is included in the cable.

In FIG. 41B, a conductor 100 is arranged on the outside of the plural core 97 coated with the insulator coated film 96, and the electromagnetic interference restrainer 98 of the present invention is arranged its outside, and the insulator 99 made of polyethylene, vinyl chloride or the like is arranged on the outside of the electromagnetic interference restrainer 98. In FIG. 41C, a drain line 101 is provided between the electromagnetic interference restrainer 98 and the conductor 100 of FIG. 41B.

The conductor 100 of FIGS. 41B and 41C and the drain line 101 of FIG. 41C electrically shield a noise similarly to the conventional cable.

(Embodiment 9)

There will be further described the method of producing the soft magnetic multi-layered film according to preferable embodiment of the present invention.

An $Fe_{78.5}Ta_{10.5}N_{11}$ thin film of 1 μm was prepared on the non-magnetic insulator substrate by using the radio-frequency (RF) sputtering device adopting a system that RF bias can be applied to the substrate during the deposition according to the reactive sputtering method, and this thin film underwent heat treatment at 550°C for 1 hour in a vacuum in a non-magnetic field.

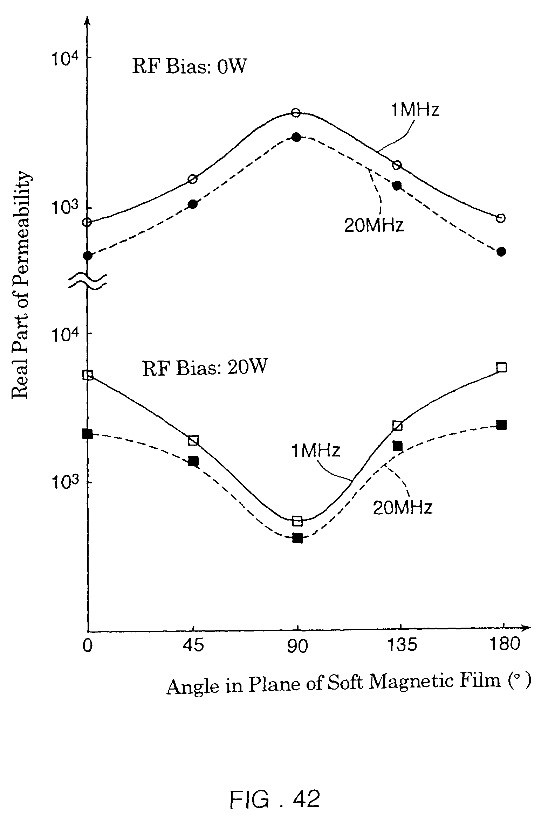

As one example, FIG. 42 shows a change in real parts μ' (1 MHz and 20 MHz) of permeability in planes of the Fe-Ta-N thin film prepared by applying RF bias of 20 W to the substrate during the deposition and the Fe-Ta-N thin film prepared without bias.

As shown in FIG. 42, both the non-bias film and the film prepared with the RF bias of 20 W show uniaxial magnetic anisotropy, and it is found that a direction showing high permeability is rotated at 90° by the RF biases of 0 W and 20 W. In such a manner, the bias is applied to the substrate during the deposition so that the direction showing high permeability in the plane of the soft magnetic film (direction of uniaxial magnetic anisotropy) can be changed.

In the soft magnetic multi-layered film described in the embodiment 7, when the soft magnetic film prepared with bias of 0 W and the soft magnetic film with application of the RF bias are laminated via the non-magnetic film by using the above producing method, the soft magnetic multi-layered film, which includes at least one layer where the directions showing high permeability in the planes of the soft magnetic films adjacent to each other via the non-magnetic film are different, can be prepared. The electromagnetic interference restrainer in the embodiments 6 through 8 whose magnetic substance is this soft magnetic multi-layered film can absorb unnecessary electromagnetic waves that enter from various directions and at various angles.

Here, the present embodiment described the Fe-Ta-N thin film, but the same effect can be obtained in a soft magnetic film that has a composition containing Fe as a main component and including M and X, or a soft magnetic film which has a composition containing Fe as a main component and including M, X and Y. Moreover, instead of the radio-frequency sputter, a sputtering device that changes a DC current and thus changes bias, may be used for forming a thin film.

**Claims**

1.  A soft magnetic thin film containing Fe as a main component, and N, M (M is at least one kind of element selected from 4A-group element, SA-group element and 6A-group element) and at least one selected from Pt and Pd.

2.  The soft magnetic thin film according to claim 1, wherein M is a 4A-group element.

3.  The soft magnetic thin film according to claim 1, wherein M is Hf.

4.  The soft magnetic thin film according to claim 1, wherein the soft magnetic thin film has a composition including at least one kind of element selected from Pt and Pd in an amount of 0.1 to 20 atomic %.

5.  The soft magnetic thin film according to claim 4, wherein the permeability in a frequency of 1 GHz of the soft magnetic thin film is raised by including at least one selected from Pt and Pd.

**6.** The soft magnetic thin film according to claim 1, wherein the soft magnetic thin film has a composition including N in an amount of 1 to 35 atomic %, M in an amount of 0. 1 to 20 atomic % and at least one selected from Pt and Pd in an amount of 0.1 to 20 atomic %.

**7.** The soft magnetic thin film according to claim 1, wherein the soft magnetic thin film is composed of at least one phase selected from an amorphous phase and a crystallite phase.

**8.** A soft magnetic film comprising the soft magnetic thin film according to claim 1 and an Si thin film.

**9.** The soft magnetic film according to claim 8, wherein the soft magnetic film is composed of a plurality of double-layered films consisting of the soft magnetic thin film and the Si thin film.

**10.** A soft magnetic multi-layered film comprising a plurality of soft magnetic films and a plurality of non-magnetic films, each of the soft magnetic films including the soft magnetic thin film according to claim 1, wherein the soft magnetic films and the non-magnetic films are laminated alternately.

**11.** The soft magnetic multi-layered film according to claim 10, wherein the non-magnetic films have at least two kinds of thicknesses.

**12.** The soft magnetic multi-layered film according to claim 10, wherein the soft magnetic films have at least two kinds of thicknesses.

**13.** The soft magnetic multi-layered film according to claim 10, wherein the soft magnetic multi-layered film includes a pair of the soft magnetic films adjacent to each other via the non-magnetic film, and the directions showing high permeability in planes of the pair of the soft magnetic films are different from each other.

**14.** A magnetic device comprising the soft magnetic thin film according to claim 1.

**15.** An electromagnetic interference restrainer comprising the soft magnetic thin film according to claim 1.

**16.** An electromagnetic interference restrainer comprising a soft magnetic film including a soft magnetic thin film, wherein the soft magnetic thin film contains Fe as a main component, and M (M is at least one kind of element selected from 4A-group element, 5A-group element and 6A-group element) and X (X is at least one selected from B, C, N and O).

**17.** The electromagnetic interference restrainer according to claim 16, wherein the electromagnetic interference restrainer is a laminate including the soft magnetic film and a non-magnetic insulating film.

**18.** The electromagnetic interference restrainer according to claim 17, wherein the laminate further includes a conductive film.

**19.** The electromagnetic interference restrainer according to claim 17, wherein the electromagnetic interference restrainer wounds around a cable.

**20.** The electromagnetic interference restrainer according to claim 16, wherein the soft magnetic thin film further includes at least one selected from Pt and Pd.

**21.** The electromagnetic interference restrainer according to claim 16, wherein the soft magnetic film is not more than 1 $\mu$m.

**22.** The electromagnetic interference restrainer according to claim 16, wherein X is O.

**23.** A cable comprising the electromagnetic interference restrainer according to claim 16, wherein the electromagnetic interference restrainer wounds around the outer periphery of the cable.

**24.** A cable comprising the electromagnetic interference restrainer according to claim 16, wherein the electromagnetic interference restrainer is included inside of the cable.

**25.** A magnetic impedance device comprising a soft magnetic film including a soft magnetic thin film containing Fe as a main component and M (M is at least one kind of element selected from 4A-group element, 5A-group element and 6A-group element) and X (X is at least one selected from B, C, N and O).

**26.** The magnetic impedance device according to claim 25, wherein the soft magnetic thin film further includes at least one selected from Pt and Pd.

**27.** A method of producing a soft magnetic thin film, comprising forming a soft magnetic thin film, which contains Fe as a main component and M (M is at least one kind of element selected from 4A-group element, SA-group element and 6A-group element) and X (X is at least one selected from B, C, N and O), on a cooled substrate.

**28.** A method of producing a soft magnetic multi-layered film, comprising forming a soft magnetic film, which includes a soft magnetic thin film containing Fe as a main component and M (M is at least one kind of element selected from 4A-group element, 5A-group element and 6A-group element) and X (X is at least one selected from B, C, N and O), and a non-magnetic film alternately on a cooled substrate.

**29.** A method of producing a soft magnetic multi-layered film, comprising forming a soft magnetic film, which includes a soft magnetic thin film containing Fe as a main component and M (M is at least one kind of element selected from 4A-group element, 5A-group element and 6A-group element) and X (X is at least one selected from B, C, N and O), and a non-magnetic film alternately, wherein different biases are applied while at least two of the soft magnetic thin films are formed.

**30.** The method as claimed in any one of claims 27 to 29, wherein the soft magnetic thin film further includes at least one selected from Pt and Pd.

FIG . 1

FIG . 2

FIG . 3

FIG . 4A

FIG . 4B

X-ray Diffraction Intensity
(arbitrary units)

Nitrogen Partial Pressure: 7%

40          50

$2\theta(°)$

FIG . 4C

FIG . 4D

Nitrogen Partial Pressure: 10%

X-ray Diffraction Intensity (arbitrary units)

$2\theta(°)$

40        50

FIG . 4E

Nitrogen Partial Pressure: 14%

X-ray Diffraction Intensity
(arbitrary units)

$2\theta(°)$

40

50

FIG . 4F

FIG . 4G

FIG . 4H

FIG . 5

FIG.6

FIG . 7

FIG . 8

FIG . 9

FIG . 10

FIG . 11

FIG . 12

FIG . 13

FIG . 14

FIG.15

FIG.16

FIG. 17

FIG.18

FIG . 19

FIG . 20

FIG . 21

FIG . 22

FIG . 23

14b  13c

13a

14c  13b

14b  13b

14a  13a

12

FIG . 24

FIG . 25

30

32a

32b

33

34

31

FIG . 26

FIG . 27

FIG . 28

50

54

FIG . 29

FIG . 30

FIG . 31

FIG . 32

FIG . 33

75

a        a'

74

73

71

FIG . 34

FIG . 35

FIG . 36A

FIG . 36B

FIG . 37A

FIG . 37B

FIG . 37C

86      87      88

FIG . 38

FIG . 39A

FIG . 39B

FIG . 40

98

99

96

97

FIG . 41A

98

100

99

96

97

FIG . 41B

98

101

100

99

96

97

FIG . 41C

FIG . 42